# EUROPÄISCHE PATENTSCHRIFT

(11) **EP 4 025 750 B1**
(45) Veröffentlichungstag und Bekanntmachung des Hinweises auf die Patenterteilung: **25.12.2024**
(21) Anmeldenummer: 20765233.0
(22) Anmeldetag: 27.08.2020
(51) Int. Cl.: E05B 17/10, E05B 77/34, E05B 81/76, H01H 9/04, H01H 13/18, E05B 83/18, H03K 17/95, H03K 17/955, H03K 17/97, H03K 17/975, H01H 13/06

(54) **BETÄTIGUNGSVORRICHTUNG MIT BEWEGBAREM SCHALTELEMENT, FAHRZEUG SOWIE BETÄTIGUNGSVERFAHREN**
ACTUATION DEVICE WITH MOVABLE SWITCH ELEMENT, VEHICLE, AND ACTUATION METHOD
DISPOSITIF D'ACTIONNEMENT À ÉLÉMENT DE COMMUTATION MOBILE, VÉHICULE ET PROCÉDÉ D'ACTIONNEMENT

(30) Priorität: 05.09.2019 DE 102019123841; 27.12.2019 DE 102019135829; 18.08.2020 DE 102020121603
(43) Veröffentlichungstag der Anmeldung: 13.07.2022
(73) Patentinhaber: Huf Hülsbeck & Fürst GmbH & Co. KG, 42551 Velbert (DE)
(72) Erfinder: BOCZEK, Artur, 42113 Wuppertal (DE); BUSCHMANN, Gerd, 42553 Velbert (DE)
(74) Vertreter: Bals & Vogel Patentanwälte PartGmbB
(86) Internationale Anmeldenummer: PCT/EP2020/073977
(87) Internationale Veröffentlichungsnummer: WO 2021/043666

(56) Entgegenhaltungen:
- EP-A2- 1 108 834
- WO-A1-01/40607
- WO-A1-2018/197771
- DE-A1- 102014 107 407
- US-A1- 2008 034 821
- US-A1- 2015 368 935
- US-A1- 2018 209 182

## Beschreibung

Die Erfindung betrifft eine Betätigungsvorrichtung, ein Fahrzeug sowie ein Betätigungsverfahren.

Aus dem Stand der Technik sind Betätigungsvorrichtungen für Fahrzeuge bekannt. Diese werden üblicherweise an einem beweglichen Teil, wie einer Heckklappe, montiert, um einem Benutzer das Öffnen des beweglichen Teils zu ermöglichen. Das Öffnen wird dabei über einen elektrischen Schalter ausgelöst, der in Abhängigkeit von der Betätigung durch den Benutzer ein elektrisches Schaltsignal ausgibt. Gerade im Außenbereich des Fahrzeuges ist eine Abdichtung derartiger Schalter jedoch häufig komplex. Weiterhin werden die Betätigungsvorrichtungen teilweise in einer Mulde des Fahrzeugbleches angeordnet. Daher ist es wünschenswert, die Betätigungsvorrichtungen möglichst kompakt, insbesondere möglichst flach, auszugestalten.

Normalerweise ist ein elektrischer Schalter bei derartigen Betätigungsvorrichtungen ferner am zum Fahrzeug feststehenden Gehäuseteil angeordnet. Da der zum Betätigen der jeweiligen Betätigungsvorrichtung bewegliche Gehäuseteil jedoch zumeist zusätzlich nur eine Abdichtfunktion hat, wird dort insbesondere bei einem elektromagnetischen Schalter meist ein zusätzliches Metallteil integriert, um den Schalter auszulösen.

Es ist eine Aufgabe der vorliegenden Erfindung, voranstehende, aus dem Stand der Technik bekannte Nachteile zumindest teilweise zu beheben. Insbesondere ist es eine Aufgabe der vorliegenden Erfindung eine kompakte, vorzugsweise flache, Betätigungsvorrichtung zu ermöglichen, bei der ein Schaltmittel bei verbesserter Betätigungsmöglichkeit gegenüber der Umgebung geschützt ist.

Die Dokumente US 2018/209182 A1, WO 2018/197771 A1, EP 1 108 834 A2 oder WO 01/40607 A1 offenbaren unterschiedliche Arten von Betätigungsvorrichtungen.

Die voranstehende Aufgabe wird gelöst durch eine Betätigungsvorrichtung mit den Merkmalen des Anspruchs 1, ein Fahrzeug mit den Merkmalen des Anspruchs 14, sowie ein Betätigungsverfahren mit den Merkmalen des Anspruchs 15. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Betätigungsvorrichtung beschrieben sind, selbstverständlich auch im Zusammenhang mit dem erfindungsgemäßen Fahrzeug und/oder dem erfindungsgemäßen Betätigungsverfahren und jeweils umgekehrt, so dass bezüglich der Offenbarung zu den einzelnen Erfindungsaspekten stets wechselseitig Bezug genommen wird bzw. werden kann. Gemäß einem ersten Aspekt der Erfindung ist eine Betätigungsvorrichtung zur Montage an einem Fahrzeugteil, insbesondere in Form einer Tür oder einer Klappe, vorgesehen. Die Betätigungsvorrichtung weist ein elektrisches Schaltmittel mit zumindest einem Schaltelement zum Auslösen einer Fahrzeugfunktion auf. Ferner weist die Betätigungsvorrichtung eine Gehäuseeinheit mit zumindest einem ersten und einem zweiten Gehäuseabschnitt auf. Der zweite Gehäuseabschnitt ist zumindest bereichsweise oder vollständig relativ zu dem ersten Gehäuseabschnitt von einer Ruheposition in eine Betätigungsposition zum Betätigen des Schaltelementes bewegbar. Dabei ist ferner vorgesehen, dass das Schaltelement am zweiten Gehäuseabschnitt angeordnet ist, so dass das Schaltelement bei der Bewegung des zweiten Gehäuseabschnitts von der Ruheposition in die Betätigungsposition mitbewegt wird.

Insbesondere ist die Betätigungsvorrichtung zum Auslösen einer Fahrzeugfunktion infolge einer Betätigung durch einen Benutzer und/oder infolge einer Betätigung des Schaltmittels ausgebildet. Vorzugsweise ist die Betätigungsvorrichtung an einer Außenseite des Fahrzeugteils anordbar. Bei dem Fahrzeugteil kann es sich beispielsweise um ein Fahrzeugblech handeln. Insbesondere kann das Fahrzeugteil ein bewegliches Fahrzeugteil, wie z.B. eine Fahrzeugtür, eine Klappe und/oder eine Heckklappe sein. Es ist jedoch ebenfalls denkbar, dass die Betätigungsvorrichtung an einem starren Fahrzeugteil anordbar ist, um beispielsweise ein daneben angeordnetes bewegliches Fahrzeugteil zu betätigen. Insbesondere kann die Betätigungsvorrichtung einen Druckschalter, insbesondere mit einem Fahrzeugemblem, oder einen Türgriff bilden. Weiterhin ist es auch denkbar, dass die Betätigungsvorrichtung in einem Innenbereich des Fahrzeuges anordbar ist.

Das elektrische Schaltmittel ist vorzugsweise dazu ausgebildet ein elektrisches Schaltsignal auszusenden, wenn der zweite Gehäuseabschnitt von der Ruheposition in die Betätigungsposition bewegt wird. Bei dem elektrischen Schaltelement kann es sich z.B. um einen elektrischen Schalter, insbesondere einen Mikroschalter handeln. Ferner ist es denkbar, dass es sich bei dem elektrischen Schaltelement um eine elektronische Komponente handelt, die im Zusammenwirken mit einer weiteren Komponente zum Erkennen der Betätigung ausgebildet ist. Beispielsweise kann das elektrische Schaltelement ein Halbleiterbauteil umfassen, welches bei Betätigung der Betätigungsvorrichtung das elektrische Schaltsignal ausgibt. Insbesondere kann das Schaltmittel mehrere Schaltelemente aufweisen, um unterschiedliche Fahrzeugfunktionen ansteuern zu können und/oder um einen durch das Schaltmittel erfassbaren Betätigungsbereich zu vergrößern.

Um eine Stromversorgung und/oder Signalführung des elektrischen Schaltmittels zu gewährleisten, kann eine Verkabelung zur Stromversorgung und/oder Signalführung des elektrischen Schaltelementes zumindest teilweise mit dem elektrischen Schaltelement mitbewegbar sein. Weiterhin ist es denkbar, dass eine Kabelführung flexibel ausgestaltet ist, um die Bewegung des elektrischen Schaltelementes zu ermöglichen. Insbesondere wenn eine bei der Bewegung von der Ruheposition in die Betätigungsposition zurückgelegte Wegstrecke kurz ist, kann auch lediglich ein flexibler Verkabelungsabschnitt in unmittelbarer Nähe des Schaltelementes vorgesehen sein, um die Stromversorgung und/oder Signalführung des Schaltelementes zu ermöglichen. Dabei ist es insbesondere denkbar, dass die Gehäuseeinheit eine Öffnung zur Kabelführung aufweist, die an einem Durchbruch zu einem Fahrzeuginnenraum anordbar ist. Im Fahrzeuginnenraum kann eine geringe Feuchtigkeit vorliegen, die für eine Funktionstüchtigkeit des Schaltmittels tolerierbar ist.

Der erste und zweite Gehäuseabschnitt können jeweils zumindest ein Gehäuseelement aufweisen. Dabei kann ein erstes Gehäuseelement des ersten Gehäuseabschnitts mit einem zweiten Gehäuseelement des zweiten Gehäuseabschnitts in einem Verbindungsbereich aneinander befestigt sein. Vorzugsweise können der erste und zweite Gehäuseabschnitt nur im Verbindungsbereich aneinander befestigt sein. Bei der Bewegung des zweiten Gehäuseabschnitts von der Ruheposition in die Betätigungsposition kann das zweite Gehäuseelement beispielsweise vollständig bewegt oder bereichsweise deformiert werden.

Zur Betätigung des Schaltelementes in der Betätigungsposition ist am ersten Gehäuseabschnitt, ein Auslöserelement vorgesehen, das mit dem Schaltelement wirkt, um ein elektrisches Schaltsignal des Schaltelementes auszulösen. Dadurch, dass das Schaltelement am zweiten Gehäuseabschnitt angeordnet ist und sich bei der Bewegung des zweiten Gehäuseabschnitts von der Ruheposition in die Betätigungsposition zumindest teilweise mitbewegt, kann die Bewegung des zweiten Gehäuseabschnitts von der Ruheposition in die Betätigungsposition zu einer Verkürzung eines Abstands zwischen einem Auslöserelement zum Auslösen des Schaltelementes und dem Schaltelement führen. Die Bewegung des zweiten Gehäuseabschnitts von der Ruheposition in die Betätigungsposition umfasst insbesondere eine Bewegung in Richtung des ersten Gehäuseabschnitts. Bei der Verkürzung des Abstands zwischen dem Auslöserelement und dem Schaltelement kann eine Änderung eines elektrischen und/oder magnetischen Feldes zwischen dem Auslöserelement und dem Schaltelement vorteilhaft erfassbar sein oder eine mechanische Betätigung des Schaltelementes erfolgen. Dadurch kann die Betätigungsvorrichtung kompakt ausgestaltet sein und eine vorteilhafte Betätigungsdetektion ermöglichen. Vorzugsweise kann das Auslöserelement ferner einer weiteren Funktion zugeordnet werden. Beispielsweise kann das Auslöserelement durch

einen Teil eines Fahrzeugblechs des beweglichen Teils oder ein anderes Metallteil gebildet sein.

Weiterhin kann bei einer erfindungsgemäßen Betätigungsvorrichtung vorteilhafterweise vorgesehen sein, dass der erste und zweite Gehäuseabschnitt zumindest teilweise oder vollständig einen Gehäuseinnenraum bilden, in welchem das Schaltelement angeordnet ist. Dadurch kann das Schaltelement vor äußeren Umwelteinflüssen, wie Feuchtigkeit, geschützt sein. Der Gehäuseinnenraum kann in mehrere Teilabschnitte unterteilt sein, in welchen z.B. das Auslöserelement und das Schaltelement voneinander separiert angeordnet sind. Der Gehäuseinnenraum kann zwischen dem ersten und dem zweiten Gehäuseabschnitt einen Bewegungsfreiraum zum Bewegen des zweiten Gehäuseabschnitts von der Ruheposition in die Betätigungsposition aufweisen. Vorzugsweise ist der zweite Gehäuseabschnitt bei der Bewegung von der Ruheposition in die Betätigungsposition in den Bewegungsfreiraum zumindest teilweise hineinbewegbar. Der Bewegungsfreiraum kann durch einen Anschlag begrenzt sein. Vorzugsweise ist der Bewegungsfreiraum derart ausgebildet, dass der zweite Gehäuseabschnitt bei der Bewegung von der Ruheposition in die Betätigungsposition zumindest bereichsweise oder vollständig eine Wegstrecke von kleiner oder gleich 5 mm, vorzugsweise von kleiner oder gleich 1 mm, besonders bevorzugt von 0,1 mm bis 0,3 mm zurücklegt. Dadurch kann ein Tastimpuls oder ein Streichen über die Betätigungsvorrichtung ausreichen, um das Schaltelement zu betätigen.

Vorzugsweise ist im Rahmen der Erfindung vorgesehen, dass sich der Gehäuseinnenraum zumindest bereichsweise zwischen dem zweiten Gehäuseabschnitt und einem fluiddichten Verformungsbereich zur elastischen Verformung des ersten Gehäuseabschnitts erstreckt. Der Verformungsbereich kann mit einem umlaufenden Verbindungsbereich des ersten und zweiten Gehäuseabschnittes mechanisch gekoppelt sein, so dass der Verbindungsbereich bei der Bewegung des zweiten Gehäuseabschnitts von der Ruheposition in die Betätigungsposition mitbewegbar ist. Insbesondere ist der Verformungsbereich zur elastischen Verformung ausgebildet. Dadurch kann eine Rückverformung automatisch erfolgen, wenn der zweite Gehäuseabschnitt von der Betätigungsposition in die Ruheposition bewegt wird. In der Betätigungsposition kann der zweite Gehäuseabschnitt, beispielsweise durch den Verformungsbereich, elastisch vorgespannt sein, so dass der zweite Gehäuseabschnitt automatisch in die Ruheposition zurückkehrt. Dadurch, dass sich der Gehäuseinnenraum zwischen dem zweiten Gehäuseabschnitt und dem Verformungsbereich erstreckt, liegt der Verformungsbereich von einer Außenseite der Betätigungsvorrichtung gesehen insbesondere unterhalb des zweiten Gehäuseabschnitts. Dadurch kann insbesondere seitlicher Bauraum eingespart werden. Der Verbindungsbereich ist insbesondere um den Gehäuseinnenraum und/oder den ersten und/oder zweiten Gehäuseabschnitt umlaufend ausgebildet. Beispielsweise kann der Verbindungsbereich regelmäßig oder unregelmäßig um den Umfang des Gehäuseinnenraums und/oder des ersten und/oder zweiten Gehäuseabschnitts verteilte Verbindungsabschnitte umfassen. Durch den Verbindungsabschnitt sind der erste und zweite Gehäuseabschnitt insbesondere aneinander befestigt. Vorzugsweise weist der erste und/oder zweite Gehäuseabschnitt und/oder der Gehäuseinnenraum einen kreisartigen Umfang auf. Dabei kann sich der Verbindungsbereich vorteilhafterweise entlang des kreisartigen Umfangs erstrecken. Vorzugsweise kann der Gehäuseinnenraum ein geschlossenes, insbesondere fluiddichtes, Volumen umfassen.

Durch die mechanische Kopplung des Verformungsbereiches und des umlaufenden Verbindungsbereiches kann der zweite Gehäuseabschnitt vollflächig mittelbar oder unmittelbar betätigbar sein. Vorzugsweise kann durch die Betätigungsvorrichtung eine, insbesondere außenliegende, Betätigungsfläche zur Verfügung gestellt werden, die vollflächig zur Betätigung des Schaltmittels genutzt werden kann. Gleichzeitig kann die Betätigungsvorrichtung eine kompakte, d.h. insbesondere flach am Fahrzeugteil anordbare, Form aufweisen. Über den Verformungsbereich kann ferner eine vorteilhafte Bewegbarkeit des zweiten Gehäuseelementes erzielt werden. Dabei kann der Gehäuseinnenraum mit dem Schaltelement durch den Verformungsbereich zumindest bereichsweise vor Umwelteinflüssen schützbar sein.

Weiterhin kann bei einer erfindungsgemäßen Betätigungsvorrichtung vorteilhafterweise vorgesehen sein, dass der Verbindungsbereich zur fluiddichten Verbindung des ersten und zweiten Gehäuseabschnitts ausgebildet ist, insbesondere wobei der Verbindungsbereich eine kontinuierlich umlaufende Verbindung des ersten und zweiten Gehäuseabschnitts umfasst. Insbesondere kann die fluiddichte Verbindung durch die kontinuierlich umlaufende Verbindung ermöglicht sein. Alternativ kann ein Dichtelement vorgesehen sein, das unverbundene Abschnitte abdichtet. Durch die fluiddichte Verbindung kann der Verbindungsbereich den Gehäuseinnenraum vollständig umlaufend abdichten, um das Schaltelement vor Umwelteinflüssen zu schützen. Ferner kann durch die fluiddichte Verbindung der Verbindungsbereich z.B. an einem äußeren Umfang der Betätigungsvorrichtung angeordnet sein.

Weiterhin ist es bei einer erfindungsgemäßen Betätigungsvorrichtung denkbar, dass der Verbindungsbereich eine stoffschlüssige Verbindung des ersten und zweiten Gehäuseabschnitts umfasst, insbesondere wobei der erste Gehäuseabschnitt mit dem zweiten Gehäuseabschnitt verklebt oder verschweißt ist. Durch die stoffschlüssige Verbindung kann eine separate Dichtung, z.B. in Form eines Elastomers, für den Gehäuseinnenraum nicht notwendig sein. Vorteilhafterweise kann der Verbindungsbereich eine umlaufende Schweißnaht aufweisen. Somit kann gleichzeitig eine Befestigung und eine zuverlässige Abdichtung des Gehäuseinnenraums am Verbindungsbereich erzielt werden. Beispielsweise können der erste und zweite Gehäuseabschnitt durch eine Dichtpaste oder durch ein doppelseitiges Klebeband verklebt sein. Vorzugsweise weisen der erste und zweite Gehäuseabschnitt einen Kunststoff auf. Dadurch kann eine einfache Schweißverbindung ermöglicht sein. Weiterhin hat eine stoffschlüssige Verbindung den Vorteil, dass die dadurch erzielte Abdichtung ein hohes Maß an Prozesssicherheit bietet. Beispielsweise kann eine Fehlmontage eines zusätzlichen Bauteils, wie eines Dichtrings oder eines doppelseitigen Klebebandes, ausgeschlossen sein.

Im Rahmen der Erfindung ist vorgesehen, dass das Schaltmittel zumindest ein Auslöserelement zum Betätigen des Schaltelementes aufweist, wobei das Auslöserelement am ersten Gehäuseabschnitt angeordnet ist, so dass das Schaltelement beim Bewegen des zweiten Gehäuseabschnitts von der Ruheposition in die Betätigungsposition auf das Auslöserelement zubewegt wird. Das Auslöserelement kann als elektrisches Gegenelement zum Schaltelement ausgebildet sein, um das Schaltelement auszulösen. Ferner ist es denkbar, dass das Auslöserelement einen mechanischen Anschlag umfasst, durch welchen das Schaltelement mechanisch betätigbar ist, um ein elektrisches Schaltsignal auszulösen. Das Auslöserelement kann vorzugsweise zumindest eine weitere Funktion, wie z.B. eine Abdichtungsfunktion, eine Rückstellfunktion zum Zurückstellen des zweiten Gehäuseabschnitts in die Ruheposition und/oder dergleichen aufweisen. Durch das Auslöserelement kann somit in einfacher Art und Weise eine Betätigung des Schaltelementes, insbesondere ohne Erhöhung der Anzahl der Bauteile, ermöglicht werden.

Weiterhin kann bei einer erfindungsgemäßen Betätigungsvorrichtung vorteilhafterweise vorgesehen sein, dass das Schaltmittel eine elektromagnetische Sensoreinheit mit einem elektrisch leitfähigen Leiterelement umfasst, welches das Auslöserelement bildet, wobei das Schaltelement zum elektromagnetischen, insbesondere induktiven oder kapazitiven, Erfassen des Leiterelementes ausgebildet ist. Vorzugsweise umfasst das Schaltelement dabei eine Spule. Beispielsweise kann die Sensoreinheit einen oder mehrere LDC-Sensoren aufweisen. Dadurch kann eine benötigte Wegstrecke des zweiten Gehäuseabschnitts von der Ruheposition in die Betätigungsposition verkürzt sein. Das Leiterelement kann vorteilhafterweise ein Metall, insbesondere eine Metallfolie, umfassen. Vorzugsweise ist das Leiterelement mit dem ersten Gehäuseabschnitt mechanisch gekoppelt oder in den ersten Gehäuseabschnitt integriert. Durch die elektromagnetische Sensoreinheit kann vorteilhafterweise eine Bewegung des Leiterelementes über ein elektrisches Feld, d.h. beispielsweise durch eine Änderung des elektrischen Feldes, erfassbar sein. Das Erfassungsmittel kann eine Messvorrichtung zum direkten oder indirekten Messen einer elektromagnetischen Größe umfassen. Somit kann es sich bei dem Schaltmittel um eine induktive oder kapazitive Sensoreinheit handeln. Insbesondere bei einer induktiven Sensoreinheit kann das Schaltelement mehrere Schaltelemente aufweisen, um einen großen Betätigungsbereich und/oder Detektionsbereich zu ermöglichen.

Es ist ferner denkbar, dass das Schaltmittel ein Erfassungselement zum Erfassen einer Annäherung eines Benutzers umfasst, vorzugsweise durch welches das Schaltelement bei der Annäherung des Benutzers von einem Deaktivierungszustand, in welchem das Auslösen der Fahrzeugfunktion durch das Schaltelement verhindert ist, in einen Aktivierungszustand bringbar ist, in welchem das Auslösen der Fahrzeugfunktion durch das Schaltelement ermöglicht ist. Im Deaktivierungszustand kann ein Betätigen des Schaltelementes verhindert und im Aktivierungszustand ein Betätigen des Schaltelementes ermöglicht sein. Dazu kann das Schaltelement z.B. elektrisch von einer elektrischen Verbindung zum Fahrzeug und/oder zu einer Elektronik der Betätigungsvorrichtung trennbar sein. Ferner ist es denkbar, dass das Auslösen der Fahrzeugfunktion im Deaktivierungszustand durch eine Software verhindert ist. Das Erfassungselement kann vorzugsweise einen Annäherungssensor umfassen. Bei dem Annäherungssensor kann es sich z.B. um einen kapazitiven Sensor handeln. Es ist jedoch ebenfalls denkbar, dass das Erfassungselement zur Authentifizierung eines Benutzers ausgebildet ist. Beispielsweise kann der Annäherungssensor eine UWB- und/oder NFC-Schnittstelle, insbesondere in Form einer Antenne, umfassen. Ferner ist es denkbar, dass das Erfassungselement eine Bluetooth-Schnittstelle, insbesondere in Form einer Bluetooth-Low-Energy-Schnittstelle (BLE-Schnittstelle), umfasst. Durch die Erfassung der Annäherung kann eine Wahrscheinlichkeit einer Fehlauslösung z.B. während einer Fahrt des Fahrzeuges verringert werden. Durch die anschließend ermöglichte, insbesondere manuelle, Betätigung des Schaltmittels kann eine Sicherheit der Betätigungsvorrichtung ferner gesteigert sein.

Weiterhin kann bei einer erfindungsgemäßen Betätigungsvorrichtung vorteilhafterweise vorgesehen sein, dass das Schaltmittel zumindest zwei oder mehr elektrische Schaltelemente aufweist, die in einer Betätigungsrichtung angeordnet sind, so dass durch ein Streichen über die Betätigungsvorrichtung, insbesondere entlang der Betätigungsrichtung, eine Betätigungsfolge bewirkbar ist, in welcher die Schaltelemente nacheinander oder unterschiedlich betätigt werden. Beispielsweise können mehrere Schaltelemente in einer Reihe angeordnet sein, die die Betätigungsrichtung definiert. Die Betätigungsfolge kann mehrere Betätigungslagen des zweiten Gehäuseabschnitts umfassen. Insbesondere kann der zweite Gehäuseabschnitt in jeder der Betätigungslagen einen unterschiedlichen Kippwinkel aufweisen, wodurch sich jeweils unterschiedliche Abstände der Schaltelemente zum ersten Gehäuseabschnitt und/oder zu einem dem jeweiligen Schaltelement zugeordneten Auslöserelement ergeben. Insbesondere können auch mehrere Auslöserelemente am ersten Gehäuseabschnitt angeordnet sein. Durch die Betätigungsfolge kann eine komplexe Betätigungshandlung erkennbar sein. Somit kann eine Erkennung eines Wunsches des Benutzers verbessert werden. Beispielsweise können Fehlerkennungen und/oder versehentliche Betätigungshandlungen reduziert werden. Ferner können durch unterschiedliche Betätigungshandlungen, wie unterschiedliche Betätigungsrichtungen, verschiedene Fahrzeugfunktionen auslösbar sein.

Vorzugsweise kann bei einer erfindungsgemäßen Betätigungsvorrichtung vorgesehen sein, dass das Schaltmittel an einer Leiterplatte angeordnet ist, die am zweiten Gehäuseabschnitt befestigt ist, insbesondere wobei die Leiterplatte eine Elektronik zur Auswertung von Sensordaten des Schaltmittels aufweist. Die Leiterplatte kann mittelbar oder mittelbar oder unmittelbar am zweiten Gehäuseabschnitt befestigt sein. Vorzugsweise weist der zweite Gehäuseabschnitt ein Haltemittel auf, an welchem die Leiterplatte form- kraft und/oder stoffschlüssig befestigt ist. Insbesondere kann das Haltemittel umlaufend um die Leiterplatte ausgebildet sein. Dabei kann die Leiterplatte beispielsweise in das Haltemittel eingeklemmt sein. Die Leiterplatte kann sich im Gehäuseinnenraum erstrecken oder den Gehäuseinnenraum mit dem ersten Gehäuseabschnitt und dem Verformungsabschnitt zumindest teilweise ausbilden. Durch die Auswertung der Sensordaten durch die Elektronik im Gehäuseinnenraum können Übertragungsverluste geringgehalten oder vermieden werden. Bei der Auswertung können z.B. Messwerte des Schaltmittels durch die Elektronik interpretierbar und/oder digitalisierbar sein. Vorzugsweise kann eine Fehlauslösung durch die Auswertung anhand von Messdaten mehrerer Schaltelemente des Schaltmittels erkennbar sein.

Ferner kann bei einer erfindungsgemäßen Betätigungsvorrichtung vorteilhafterweise vorgesehen sein, dass die Leiterplatte mit einer Vergussmasse vergossen ist oder mit einem Schutzlack bedeckt ist. In die Vergussmasse kann die Leiterplatte, insbesondere mit der Elektronik, vollständig eingebettet sein. Dazu kann ein Teil des Gehäuseinnenraums mit der Vergussmasse verfüllt sein. Insbesondere kann durch die Vergussmasse im Gehäuseinnenraum ein Sicherheitsbereich gebildet sein, der vorzugsweise durch die Vergussmasse und den zweiten Gehäuseabschnitt gebildet ist. Das Schaltelement ist dabei insbesondere in dem Sicherheitsbereich angeordnet. Dies hat den Vorteil, dass eine zusätzliche Absicherung gegenüber Umwelteinflüssen, insbesondere gegenüber Feuchtigkeit, geschaffen ist. Die Vergussmasse kann z.B. ein Harz, insbesondere ein Kunstharz, aufweisen. Ein Schutzlack hat den Vorteil, dass ebenfalls eine zusätzliche Absicherung gegenüber Feuchtigkeit ermöglicht sein kann. Dabei kann durch den Schutzlack nur ein geringfügiger Bauraum im Gehäuseinnenraum benötigt sein. Durch die Vergussmasse oder den Schutzlack kann die Lebensdauer der Leiterplatte und/oder der Elektronik gesteigert sein. Die Vergussmasse oder der Schutzlack kann zwischen der Leiterplatte und dem ersten und/oder zweiten Gehäuseabschnitt angeordnet sein.

Ferner kann bei einer erfindungsgemäßen Betätigungsvorrichtung vorteilhafterweise vorgesehen sein, dass der erste Gehäuseabschnitt ein Abdeckelement aufweist, welches einen Verbindungsabschnitt des Verbindungsbereiches bildet. Der Verbindungsabschnitt des Verbindungsbereiches kann mit einem Verbindungsabschnitt des zweiten Gehäuseabschnitts den Verbindungsbereich bilden. Vorzugsweise weist das Abdeckelement den Verbindungsbereich auf. Insbesondere kann durch das Abdeckelement eine fahrzeugseitige Gehäusehälfte der Gehäuseeinheit gebildet sein. Vorzugsweise weist das Abdeckelement Verbindungsschnittstellen zum Verbinden der Betätigungsvorrichtung mit dem Fahrzeugteil auf. Insbesondere kann das Abdeckelement mit dem Fahrzeugteil verschraubbar sein. Dadurch kann eine sichere Befestigung der Betätigungsvorrichtung am Fahrzeugteil ermöglicht sein. Ein Befestigungsmittel, wie z.B. eine Schraube, kann dadurch über den Gehäuseinnenraum am Abdeckelement montiert sein, so dass das Befestigungsmittel vorteilhafterweise von einer Außenseite des zweiten Gehäuseabschnitts unsichtbar ist. Das Abdeckelement kann materialeinheitlich ausgebildet sein oder als Mehrkomponenten-Kunststoffspritzgussteil. Beispielsweise kann das Abdeckelement im Verformungsbereich eine Weichkomponente aufweisen, um eine Verformung zu ermöglichen oder zu begünstigen.

Weiterhin ist es bei einer erfindungsgemäßen Betätigungsvorrichtung denkbar, dass das Abdeckelement den Verformungsbereich bildet, insbesondere wodurch eine Rückstellkraft entgegen der Bewegung des zweiten Gehäuseabschnitts von der Ruheposition in die Betätigungsposition durch das Abdeckelement ausübbar ist. Beispielsweise kann das Abdeckelement einen elastisch verformbaren Kunststoff und/oder eine biegsame Form aufweisen, um den Verformungsbereich zu bilden. Vorzugsweise kann das Abdeckelement im Verformungsbereich eine Dicke von weniger als 2 mm, besonders bevorzugt weniger als 1 mm, aufweisen. Dadurch kann eine elastische Verformung umlaufend um den Gehäuseabschnitt, d.h. insbesondere über den gesamten Umfang des Verformungsbereiches, ermöglicht sein. Durch die Rückstellkraft kann eine automatische Rückstellung des zweiten Gehäuseabschnitts in die Ruheposition ermöglicht oder unterstützbar sein.

Weiterhin ist es bei einer erfindungsgemäßen Betätigungsvorrichtung denkbar, dass die Gehäuseeinheit ein Federelement zum Ausüben einer Rückstellkraft entgegen der Bewegung des zweiten Gehäuseabschnitts von der Ruheposition in die Betätigungsposition aufweist, insbesondere wobei das Federelement im Gehäuseinnenraum angeordnet ist. Das Federelement kann vorteilhafterweise einen Federstahl oder einen elastischen Kunststoff aufweisen. Bei dem Federelement kann es sich z.B. um eine Blattfeder handeln. Das Federelement kann separat zu dem Verformungsbereich ausgebildet sein. Die Rückstellkraft kann insbesondere zusätzlich zu einer Rückstellkraft des Verformungsbereiches wirken. Es ist jedoch ebenfalls denkbar, dass das Federelement den Verformungsbereich bildet. Dabei kann das Federelement in den ersten oder zweiten Gehäuseabschnitt integriert sein, d.h. insbesondere Teil des ersten oder zweiten Gehäuseabschnitts sein. Ferner kann sich das Federelement umlaufend um den Gehäuseinnenraum und/oder das Abdeckelement erstrecken. Durch das Federelement kann der zweite Gehäuseabschnitt automatisch in die Ruheposition zurückbewegbar sein. Wenn das Federelement und der Verformungsbereich jeweils eine separate Rückstellkraft ausüben können, kann eine sich eine daraus resultierende Steifigkeit vorteilhaft auf ein Betätigungsverhalten des zweiten Gehäuseabschnitts auswirken.

Es ist ferner bei einer erfindungsgemäßen Betätigungsvorrichtung denkbar, dass das Federelement das Leiterelement des Schaltmittels bildet, insbesondere wobei eine Verkürzung eines Abstands des Federelementes zum Schaltelement durch das Schaltelement erfassbar ist, wenn der zweite Gehäuseabschnitt von der Ruheposition in die Betätigungsposition bewegt wird. Vorzugsweise weist das Federelement ein elektrisch leitfähiges Federmaterial auf oder besteht aus einem elektrisch leitfähigen Federmaterial. Dadurch kann das Federelement Teil der elektromagnetischen Sensoreinheit sein. Die Veränderung des elektrischen und/oder magnetischen Feldes durch die Verkürzung des Abstands kann durch das Schaltelement erfasst werden. Dadurch ist z.B. ein zusätzliches Leiterelement nicht notwendig. Somit kann eine geringe Anzahl von Bauteilen erreicht werden und dadurch eine Komplexität der Betätigungsvorrichtung vereinfacht sein.

Vorzugsweise kann bei einer erfindungsgemäßen Betätigungsvorrichtung vorgesehen sein, dass der Verbindungsbereich das Federelement aufweist, wobei sich das Federelement umlaufend, insbesondere um einen zentralen Bereich der Betätigungsvorrichtung, im Verbindungsbereich erstreckt. Dabei kann das Federelement vorteilhafterweise Teil des ersten Gehäuseabschnitts sein. Vorzugsweise kann das Federelement eine fluiddichte, elastisch verformbare Gehäuseoberfläche bilden. Die durch das Federelement gebildete Gehäuseoberfläche kann insbesondere fahrzeugseitig orientiert sein. Dabei kann das Federelement insbesondere den Verformungsbereich des zweiten Gehäuseabschnitts bilden. Dadurch kann die Betätigungsvorrichtung kompakt ausgebildet sein und eine zuverlässige Abdichtung bei wenigen Bauteilen ermöglichen.

Vorzugsweise kann bei einer erfindungsgemäßen Betätigungsvorrichtung vorgesehen sein, dass das Federelement form- und/oder stoffschlüssig mit dem zweiten Gehäuseabschnitt verbunden ist, insbesondere wobei das Federelement bereichsweise in ein Gehäusematerial des zweiten Gehäuseabschnitts eingebettet oder eingeklemmt ist oder wobei das Federelement durch ein Dichtmittel mit dem zweiten Gehäuseabschnitt verklebt ist. Dadurch kann das Federelement einen Verbindungsabschnitt des Verbindungsbereiches bilden. Beispielsweise kann das Federelement bereichsweise mit einem Gehäusematerial des zweiten Gehäuseabschnitts umspritzt und/oder umgossen sein. Ferner ist es denkbar, dass das Federelement in ein Gehäusematerial des zweiten Gehäuseabschnitts eingeklemmt ist. Zusätzlich oder alternativ kann das Federelement mit dem zweiten Gehäuseabschnitt über eine Dichtpaste, insbesondere in Form einer Dichtraupe, verbunden sein. Durch eine form- und/oder stoffschlüssige Verbindung des Federelementes mit dem zweiten Gehäuseabschnitt kann eine zuverlässige Verbindung des Federelementes mit dem zweiten Gehäuseabschnitt und damit eine zuverlässige Verbindung des ersten und zweiten Gehäuseabschnitts ermöglicht sein. Ferner kann dadurch eine vorteilhafte Abdichtung des Gehäuseinnenraums geschaffen sein, insbesondere ohne eine zusätzliche Dichtung zu benötigen.

Weiterhin ist es bei einer erfindungsgemäßen Betätigungsvorrichtung denkbar, dass die Gehäuseeinheit ein Positioniermittel aufweist, durch welches die Ruheposition des zweiten Gehäuseabschnitts, insbesondere formschlüssig, festlegbar ist. Aus der Ruheposition kann dadurch vorteilhaft eine erneute Bewegung des zweiten Gehäuseabschnitts von der Ruheposition in die Betätigungsposition ausführbar sein, um eine weitere Betätigung durchzuführen. Das Positioniermittel kann vorteilhafterweise ein Anschlagsmittel des zweiten Gehäuseabschnitts und ein Gegenanschlagsmittel des ersten Gehäuseabschnitts umfassen. Dabei kann das Anschlagsmittel in der Ruheposition gegen das Gegenanschlagsmittel anschlagen, um eine Rückstellbewegung des zweiten Gehäuseabschnitts zu stoppen. Insbesondere kann das Positioniermittel dazu ausgebildet sein, eine Bewegung des zweiten Gehäuseabschnitts lediglich in Richtung der Betätigungsposition zuzulassen, wenn sich der zweite Gehäuseabschnitt in der Ruheposition befindet. Vorteilhafterweise kann das Positioniermittel eine Rastverbindung umfassen. Dadurch kann eine Montage der Betätigungsvorrichtung vereinfacht sein. Beispielsweise können der erste und der zweite Gehäuseabschnitt durch das Positioniermittel miteinander verrastet sein. Dadurch kann eine Belastung des Verbindungsbereiches durch eine Rückstellkraft zu reduzieren.

Weiterhin kann bei einer erfindungsgemäßen Betätigungsvorrichtung vorteilhafterweise vorgesehen sein, dass zwischen dem ersten und zweiten Gehäuseabschnitt ein Zwischenelement angeordnet ist, durch welches die Rückstellkraft des Federelementes an den zweiten Gehäuseabschnitt übertragbar ist und/oder welches zumindest ein Positionierelement des Positioniermittels aufweist. Bei dem Positionierelement kann es sich z.B. um ein Anschlagsmittel des zweiten Gehäuseabschnitts handeln. Das Zwischenelement kann als Adapter dienen, um zusätzlich zu dem Verbindungsbereich eine Wirkverbindung zwischen dem ersten und zweiten Gehäuseabschnitt herzustellen. Dadurch können z.B. Formteile des zweiten Gehäuseabschnitts vereinfacht ausgebildet sein, um deren Herstellkosten zu reduzieren. Weiterhin kann durch das Zwischenelement eine für eine Kraftübertragung vorteilhafte Geometrie erzielt werden, die insbesondere unabhängig von einem Herstellverfahren weiterer Komponenten ist. Vorzugsweise ist das Zwischenelement am ersten und/oder zweiten Gehäuseabschnitt befestigt. Insbesondere kann das Zwischenelement im Gehäuseinnenraum angeordnet sein. Dadurch ist es z.B. nicht notwendig, dass das Zwischenelement zur Abdichtung des Gehäuseinnenraums beiträgt.

Vorzugsweise kann bei einer erfindungsgemäßen Betätigungsvorrichtung vorgesehen sein, dass zumindest teilweise oder vollständig im Gehäuseinnenraum eine Beleuchtungseinheit zum Beleuchten der Betätigungsvorrichtung anordnet ist. Durch die Beleuchtungseinheit kann eine Sichtbarkeit der Betätigungsvorrichtung, insbesondere im Dunkeln, verbessert sein. Darüber hinaus kann die Beleuchtungseinheit als Hinweis an einen Benutzer dienen, dass es sich bei dem beleuchteten Bereich am Fahrzeug um eine Betätigungsvorrichtung handelt. Dadurch kann eine intuitive Bedienung der Betätigungsvorrichtung ermöglicht sein. Die Beleuchtungseinheit kann ein oder mehrere Leuchtmittel, insbesondere in Form einer LED oder mehrerer LEDs, umfassen. Durch die Anordnung im Gehäuseinnenraum kann die Beleuchtungseinheit vorteilhafterweise vor Umwelteinflüssen geschützt sein. Beispielsweise kann die Beleuchtungseinheit auf der Leiterplatte und/oder auf einem Trägerelement des ersten Gehäuseabschnitts angeordnet sein.

Es ist ferner bei einer erfindungsgemäßen Betätigungsvorrichtung denkbar, dass der zweite Gehäuseabschnitt einen Lichtleiter zum Leiten von Licht der Beleuchtungseinheit aufweist, insbesondere wobei der Lichtleiter eine Lichtaustrittsfläche aufweist, die zur umlaufenden Beleuchtung der Betätigungsvorrichtung umlaufend um den zweiten Gehäuseabschnitt ausgebildet ist. Insbesondere kann der zweite Gehäuseabschnitt durch den Lichtleiter gebildet sein. Bei dem Lichtleiter kann es sich um ein zumindest teilweise transparentes Gehäuseelement des zweiten Gehäuseabschnitts handeln. Dabei kann der Lichtleiter einen Verbindungsabschnitt des Verbindungsbereiches bilden. Insbesondere kann die Lichtaustrittsfläche randseitig des Verbindungsbereiches ausgebildet sein. Dadurch kann eine vorteilhafte Ausnutzung des Bauraums ermöglicht sein, bei welcher Licht vorteilhaft nach außen treten kann. Durch die umlaufende Lichtaustrittsfläche kann ferner eine vorteilhafte Beleuchtung der Betätigungsvorrichtung ermöglicht sein, bei welcher die Betätigungsfläche in einem Zentralbereich der Beleuchtung liegt, der insbesondere nicht selbst ausgeleuchtet ist. Dadurch kann ein intuitiver Hinweis auf die Betätigungsvorrichtung am Fahrzeug geschaffen sein. Ferner kann dadurch z.B. eine Anordnung eines Logos, einer Anweisung und/oder eines Fahrzeugemblems im Zentralbereich ermöglicht sein, ohne das Logo, die Anweisung und/oder das Fahrzeugemblem direkt zu beeinflussen.

Ferner kann bei einer erfindungsgemäßen Betätigungsvorrichtung vorteilhafterweise vorgesehen sein, dass der zweite Gehäuseabschnitt ein Fahrzeugemblem aufweist, welches eine Betätigungsfläche zum Auslösen der Bewegung des zweiten Gehäuseabschnitts von der Ruheposition in die Betätigungsposition bildet, insbesondere wobei das Fahrzeugemblem, insbesondere vollständig, eine Außenseite der Betätigungsvorrichtung bildet. Insbesondere kann das Fahrzeugemblem am Lichtleiter und/oder einem Gehäuseelement des zweiten Gehäuseabschnitts angeordnet sein. Das Fahrzeugemblem kann somit einen intuitiven Hinweis für den Benutzer auf die Betätigungsfläche bilden. Ferner kann dadurch ein Bereich am Fahrzeug für die Betätigung genutzt werden, der ohnehin ein weiteres Bauteil aufweist, das sich von dem Fahrzeugteil, an dem die Betätigungsvorrichtung montierbar ist, unterscheidet. Die Lichtaustrittsfläche kann insbesondere randseitig des Verbindungsbereiches angeordnet sein. Insbesondere kann die Lichtaustrittsfläche zumindest im Wesentlichen oder vollständig parallel zu einer Oberfläche des Fahrzeugteils orientiert sein. Dabei kann das Fahrzeugemblem den Gehäuseinnenraum und/oder den ersten Gehäuseabschnitt vollständig überdecken, so dass bei einer Montage der Betätigungsvorrichtung am Fahrzeugteil lediglich das Fahrzeugemblem sichtbar ist. Das Fahrzeugemblem kann eine vorteilhafte Anpassung der Betätigungsvorrichtung an eine Optik des Fahrzeuges ermöglichen und insbesondere gleichzeitig einen zusätzlichen Schutz gegenüber Schmutz bieten.

Es ist ferner bei einer erfindungsgemäßen Betätigungsvorrichtung denkbar, dass der Gehäuseinnenraum ein Ausgleichselement zum Luftaustausch mit einer Umgebung aufweist, insbesondere wobei das Ausgleichselement an einer Kabelführung für das Schaltmittel und/oder die Leiterplatte angeordnet ist. Dadurch kann z.B. eine Verkleinerung eines Volumens des Gehäuseinnenraums ermöglicht sein, insbesondere welches über eine Kompressibilität von Luft in Gehäuseinnenraum hinausgeht. Das Ausgleichselement kann als Ventil ausgebildet sein. Beispielsweise kann das Ausgleichselement eine Dichtlippe umfassen, welche bei einem Überdruck und/oder Unterdruck im Gehäuseinnenraum einen Luftaustausch ermöglicht. Die Kabelführung kann die Betätigungsvorrichtung mit einem Fahrzeuginnenraum und/oder mit einem Funktionselement für die durch die Betätigungsvorrichtung betätigbare Fahrzeugfunktion, wie z.B. einem Schloss zum Öffnen und/oder Schließen des Fahrzeugteils, verbinden. Insbesondere kann das Schaltmittel und/oder die Leiterplatte über Kabel der Kabelführung mit elektrischer Energie versorgbar sein. Dadurch kann an dieser Stelle die Wahrscheinlichkeit eines Eindringens von Schmutz in den Gehäuseinnenraum reduziert sein. Weiterhin kann durch das Ausgleichselement ein Unterdruck und/oder ein Überdruck aufgrund von Umgebungsbedingungen, wie einem Fahrverhalten des Fahrzeugs oder Temperaturschwankungen, ausgeglichen werden.

Gemäß einem weiteren Aspekt der Erfindung ist ein Fahrzeug vorgesehen. Das Fahrzeug umfasst ein Fahrzeugteil, insbesondere in Form einer Tür oder einer Klappe. Ferner ist vorgesehen, dass an dem Fahrzeugteil eine erfindungsgemäße Betätigungsvorrichtung zum Auslösen einer Fahrzeugfunktion des Fahrzeuges angeordnet ist.

Somit bringt ein erfindungsgemäßes Fahrzeug die gleichen Vorteile mit sich, wie sie bereits ausführlich mit Bezug auf eine erfindungsgemäße Betätigungsvorrichtung beschrieben worden sind. Bei dem Fahrzeug handelt es sich insbesondere um ein Kraftfahrzeug, vorzugsweise in Form eines Elektrofahrzeuges oder eines Hybridfahrzeuges. Durch die vorteilhafte Abdichtung der Betätigungsvorrichtung kann eine Elektrifizierung von Fahrzeugfunktionen vereinfacht sein. Durch die erfindungsgemäße, insbesondere kompakt ausgebildete, Betätigungsvorrichtung kann ferner ein äußeres Erscheinungsbild des Fahrzeuges verbessert sein und/oder Bauraum im Fahrzeuginneren eingespart werden. Vorzugsweise handelt es sich bei dem Fahrzeugteil um ein außenliegendes Fahrzeugteil und/oder um ein Karosserieteil des Fahrzeuges.

Gemäß einem weiteren Aspekt der Erfindung ist ein Betätigungsverfahren zum Auslösen einer Fahrzeugfunktion eines Fahrzeuges durch eine erfindungsgemäße Betätigungsvorrichtung, mit zumindest einem ersten und einem zweiten Gehäuseabschnitt, umfassend die folgenden Schritte:
- Betätigen eines elektrischen Schaltelementes eines elektrischen Schaltmittels zum Auslösen der Fahrzeugfunktion durch Bewegen des zweiten Gehäuseabschnitts mit dem Schaltelement von einer Ruheposition in eine Betätigungsposition,
- Elastisches Zurückstellen des zweiten Gehäuseabschnitts mit dem Schaltelement in die Ruheposition.

Somit bringt ein erfindungsgemäßes Betätigungsverfahren die gleichen Vorteile mit sich, wie sie bereits ausführlich mit Bezug auf eine erfindungsgemäße Betätigungsvorrichtung und/oder ein erfindungsgemäßes Fahrzeug beschrieben worden sind. Bei dem Fahrzeug kann es sich um ein erfindungsgemäßes Fahrzeug handeln. Das elastische Zurückstellen des zweiten Gehäuseabschnitts kann durch einen Verformungsbereich und/oder ein zusätzliches Federelement erfolgen. Das Betätigen des Schaltelementes erfolgt vorzugsweise induktiv. Vor dem Betätigen des Schaltelementes kann insbesondere ein Erfassen einer Annäherung erfolgen, in Abhängigkeit dessen das Schaltelement in einen Aktivierungszustand gebracht wird, in welchem das Auslösen der Fahrzeugfunktion, insbesondere das Betätigen des Schaltelementes, ermöglicht wird. Das Betätigen des Schaltelementes erfolgt insbesondere infolge der Bewegung des zweiten Gehäuseabschnitts. Wenn ein umlaufender Verbindungsbereich beim Bewegen des zweiten Gehäuseabschnitts mitbewegt wird, kann eine vollflächige Betätigungsmöglichkeit durch einen Benutzer gegeben sein. Dadurch kann eine Betätigung der Betätigungsvorrichtung vereinfacht sein. Ferner kann durch die Kopplung des Verbindungsbereiches mit dem Verformungsbereich eine kompakte Bauform der Betätigungsvorrichtung ermöglicht sein. Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Es zeigen schematisch:
- Figur 1: eine erfindungsgemäße Betätigungsvorrichtung in einer Querschnittsansicht in einem ersten Ausführungsbeispiel,
- Figur 2: die Betätigungsvorrichtung in einer vereinfachten Explosionsansicht,
- Figur 3: die Betätigungsvorrichtung in einer teilweise vergrößerten Querschnittsansicht,
- Figur 4: ein Wirkzusammenhang einer Gehäuseeinheit der Betätigungsvorrichtung,
- Figur 5: ein erfindungsgemäßes Fahrzeug mit der Betätigungsvorrichtung,
- Figur 6: ein erfindungsgemäßes Verfahren zum Auslösen einer Fahrzeugfunktion des Fahrzeuges durch die Betätigungsvorrichtung in schematischer Darstellung von Verfahrensschritten,
- Figur 7: eine erfindungsgemäße Betätigungsvorrichtung in einer teilweise vergrößerten Querschnittsansicht in einem zweiten Ausführungsbeispiel,
- Figur 8: ein Wirkzusammenhang einer Gehäuseeinheit der Betätigungsvorrichtung des zweiten Ausführungsbeispiels,
- Figur 9: eine erfindungsgemäße Betätigungsvorrichtung in einer teilweise vergrößerten Querschnittsansicht in einem weiteren Ausführungsbeispiel, und
- Fig. 10a+b: unterschiedliche Betätigungslagen der Betätigungsvorrichtung des ersten Ausführungsbeispiels zum Bewirken einer Betätigungsfolge.

In der nachfolgenden Beschreibung zu einigen Ausführungsbeispielen der Erfindung werden für die gleichen technischen Merkmale auch in unterschiedlichen Ausführungsbeispielen die identischen Bezugszeichen verwendet.

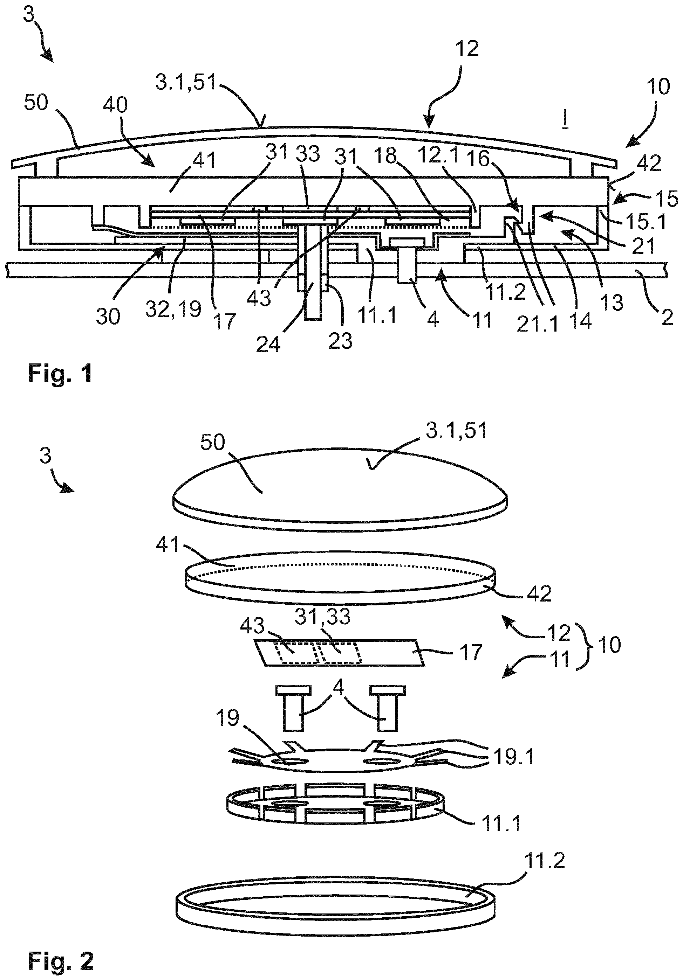

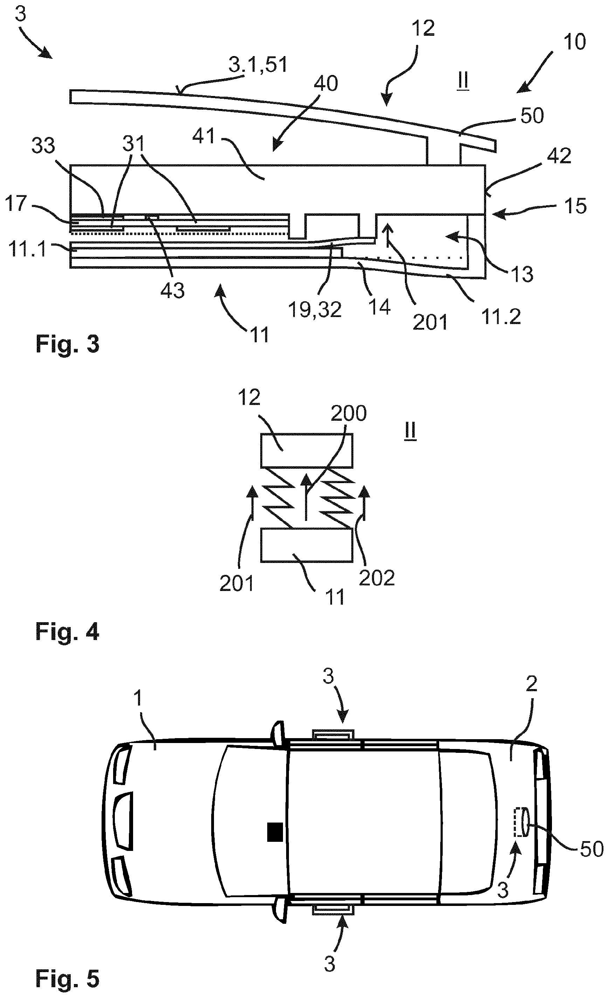

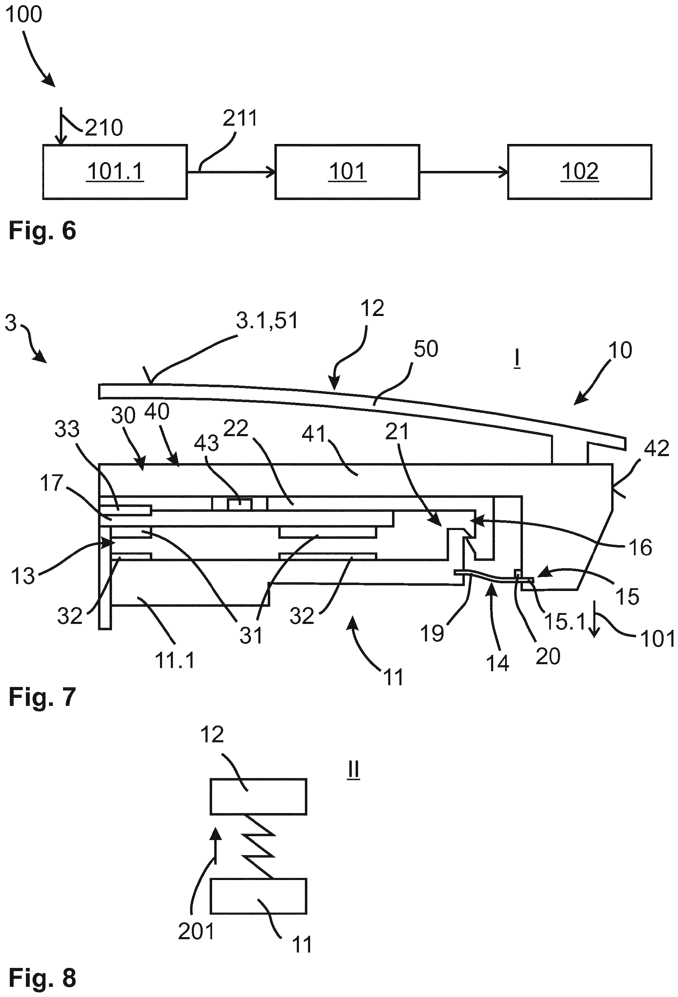

Figur 1 zeigt eine erfindungsgemäße Betätigungsvorrichtung 3, die insbesondere an einem Fahrzeugteil 2 eines erfindungsgemäßen Fahrzeuges 1 montiert ist. Das Fahrzeug 1 mit der Betätigungsvorrichtung 3 ist in Figur 5 dargestellt. Bei dem Fahrzeugteil 2 handelt es sich dabei um ein bewegliches Fahrzeugteil in Form einer Heckklappe. Es ist jedoch ebenso denkbar, dass die Betätigungsvorrichtung 3 an einem anderen Fahrzeugteil, wie z.B. einer Seitentür, oder in einem Fahrzeuginnenraum montierbar ist. Dabei kann die Betätigungsvorrichtung 3 z.B. einen Türgriff des Fahrzeugs 1 bilden oder in einen Türgriff integriert sein. Die Betätigungsvorrichtung 3 dient zum elektrischen Auslösen einer Fahrzeugfunktion des Fahrzeuges 1. Beispielsweise kann durch eine Betätigung der Betätigungsvorrichtung 3 das Fahrzeugteil 2 geöffnet werden. Die Betätigungsvorrichtung 3 kann vorzugsweise am dem Fahrzeugteil 2 durch ein Befestigungsmittel 4 befestigt sein, vorzugsweise mit dem Fahrzeugteil 2 verschraubt sein. Ein Betätigungsverfahren 100 zum Auslösen der Fahrzeugfunktion durch die Betätigungsvorrichtung 3 ist in schematischem Ablauf in Figur 6 dargestellt.

Wie in Figur 1 gezeigt, weist die Betätigungsvorrichtung 3 zum Auslösen der Fahrzeugfunktion ein elektrisches Schaltmittel 30 mit mehreren Schaltelementen 31 auf. Anstelle mehrerer Schaltelemente 31 kann die Betätigungsvorrichtung 3 auch lediglich ein Schaltelement 31 aufweisen. Die Schaltelemente 31 sind in einem Gehäuseinnenraum 13 am zweiten Gehäuseabschnitt 12 angeordnet. Der Gehäuseinnenraum 13 ist durch einen ersten und einen zweiten Gehäuseabschnitt 11, 12 einer Gehäuseeinheit 10 der Betätigungsvorrichtung 3 gebildet. Dadurch sind die Schaltelemente 31 vor Umwelteinflüssen, wie z.B. Schmutz und/oder Feuchtigkeit, geschützt. Weiterhin sind die Schaltelemente 31 in eine Vergussmasse 18 eingebettet, wodurch ein weiterer Sicherheitsbereich gegen Feuchtigkeit innerhalb des Gehäuseinnenraums 13 geschaffen ist. Zum Betätigen 101 des Schaltelementes 31 ist der zweite Gehäuseabschnitt 12 der Gehäuseeinheit 10 von einer Ruheposition I in eine Betätigungsposition II zumindest bereichsweise relativ zum ersten Gehäuseabschnitt 11 bewegbar. Die Betätigungsposition II ist in Figur 3 dargestellt. Beim Bewegen des zweiten Gehäuseabschnitts 12 wird der zweite Gehäuseabschnitt 12 in einen Bewegungsfreiraum 16 des Gehäuseinnenraums 13 zumindest bereichsweise hineinbewegt, wodurch sich ein Abstand des ersten und zweiten Gehäuseabschnitts 11, 12 im Bereich des Gehäuseinnenraums 13 verringert. Dazu weist die Betätigungsvorrichtung 3 an einer Außenseite 3.1 eine Betätigungsfläche 51 auf, auf welche ein Benutzer zum Bewegen des zweiten Gehäuseabschnitts 12 von der Ruheposition I in die Betätigungsposition II einen Druck ausüben kann. Der zweite Gehäuseabschnitt 12 weist ein Fahrzeugemblem 50 auf, welches die Außenseite 3.1 und die Betätigungsfläche 51 bildet. Insbesondere ist von der Betätigungsvorrichtung 3 von außerhalb des Fahrzeugs 1 lediglich die Außenseite 3.1 der Betätigungsvorrichtung 3 sichtbar.

Der erste Gehäuseabschnitt 11 weist ferner einen fluiddichten Verformungsbereich 14 auf, der bei der Bewegung des zweiten Gehäuseabschnitts 12 von der Ruheposition I in die Betätigungsposition II elastisch verformt wird. Zur fluiddichten Ausgestaltung des Verformungsbereiches 14 weist der erste Gehäuseabschnitt 11 ein Abdeckelement 11.2 auf, das schalenartig ausgestaltet ist, wie in der vereinfachten Explosionsansicht in Figur 2 gezeigt. Der Gehäuseinnenraum 13 erstreckt sich ferner zumindest bereichsweise zwischen dem zweiten Gehäuseabschnitt 12 und dem Verformungsbereich 14. Dabei ist der Verformungsbereich 14 insbesondere zwischen dem Fahrzeugteil 2 und dem zweiten Gehäuseabschnitt 12 angeordnet, wodurch eine kompakte Ausgestaltung der Betätigungsvorrichtung 3 ermöglicht ist. Das Abdeckelement 11.2 kann materialeinheitlich ausgebildet sein oder im Verformungsbereich 14 eine Weichkomponente 14.1 aufweisen.

Weiterhin sind der erste und zweite Gehäuseabschnitt 11, 12 in einem, insbesondere um den Gehäuseinnenraum 13, umlaufenden Verbindungsbereich 15 miteinander fluiddicht verbunden. Vorzugsweise ist der Verbindungsbereich 15 dabei kontinuierlich umlaufend ausgebildet und umfasst eine stoffschlüssige Verbindung des ersten und zweiten Gehäuseabschnitts 11, 12. Beispielsweise können der erste und zweite Gehäuseabschnitt 11, 12 im Verbindungsbereich 15 miteinander verschweißt oder verklebt sein, um eine kontinuierlich umlaufende Abdichtung des Gehäuseinnenraums 13 im Verbindungsbereich 15 zu gewährleisten. Der Verformungsbereich 14 und der Verbindungsbereich 15 sind ferner mechanisch miteinander gekoppelt, so dass der Verbindungsbereich 15 bei einer Verformung des Verformungsbereiches 14 infolge der Bewegung des zweiten Gehäuseabschnitts 12 von der Ruheposition I in die Betätigungsposition II mitbewegbar ist. Das Abdeckelement 11.2 bildet dabei den Verformungsbereich 14 und einen Verbindungsabschnitt 15.1 des Verbindungsbereiches 15. Dadurch kann ein Benutzer die Betätigungsfläche 51 der Betätigungsvorrichtung 3 vollflächig zum Betätigen nutzen. Je nach Ausgestaltung des Schaltmittels 30 spielt es dabei keine Rolle, ob der Benutzer lediglich in einem bestimmten Bereich auf die Außenseite 3.1 drückt, wodurch eine Bedienung der Betätigungsvorrichtung 3 vereinfacht ist.

Die Gehäuseeinheit 10 weist ferner ein Federelement 19 auf, das beim Bewegen des zweiten Gehäuseabschnitts 12 von der Ruheposition I in die Betätigungsposition II eine Rückstellkraft 201 auf den zweiten Gehäuseabschnitt 12 ausübt. Das Federelement 19 kann plattenartig ausgestaltet sein. Vorzugsweise umfasst das Federelement 19 mehrere Federbereiche 19.1, um eine umlaufende Federwirkung zu ermöglichen. Eine Wechselwirkung des ersten und zweiten Gehäuseabschnittes 11, 12 mit dem Federelement 19 und dem Verformungsbereich 14 ist in Figur 4 dargestellt. Dabei besitzen der Verformungsbereich 14 und das Federelement 19 insbesondere unterschiedliche Federsteifigkeiten. Eine elastische Gesamtkraft 200 ergibt sich aus einer Rückstellkraft 202 des Verformungsbereiches 14 und der Rückstellkraft 201 des Federelementes 19. Dadurch kann automatisch ein elastisches Zurückstellen 102 des zweiten Gehäuseabschnitts 12 in die Ruheposition I erfolgen, insbesondere nachdem ein Benutzer einen Druck vom zweiten Gehäuseabschnitt 12 gelöst hat. Ferner kann dadurch eine vorteilhafte Steifigkeit der Betätigungsvorrichtung 3, insbesondere beim Betätigen, ermöglicht sein. Um den zweiten Gehäuseabschnitt 12 im unbetätigten Zustand in der Ruheposition I, insbesondere formschlüssig, zu fixieren, weist die Gehäuseeinheit 10 ferner ein Positioniermittel 21 auf. Dabei handelt es sich vorzugsweise um Rastverbindung, bei welcher ein Positionierelement 21.1 in Form eines Anschlagsmittels des zweiten Gehäuseabschnitts 12 an einem Positionierelement 21.1 in Form eines Gegenanschlagsmittels des zweiten Gehäuseabschnitts 12 in der Ruheposition I anliegt. Um einen Luftaustausch des Gehäuseinnenraums 13 mit einer Umgebung zu ermöglichen kann ein Ausgleichselement 23 in eine Kabelführung für eine Verkabelung 24 integriert sein oder an der Kabelführung angeordnet sein. Alternativ zum Ausgleichselement 23 kann beispielsweise ein Durchbruch zu einem Fahrzeuginnenraum vorgesehen sein, so dass die Verkabelung 24 im Bereich des Durchbruchs vorzugsweise frei bewegbar ist.

Das Schaltmittel 30 umfasst eine elektromagnetische Sensoreinheit, insbesondere in Form eines LDC-Sensors. Das Federelement 19 ist im Gehäuseinnenraum 13 angeordnet und bildet ein Auslöserelement 32 elektrisch leitfähiges Leiterelement des Schaltmittels 30 zum Auslösen der Schaltelemente 31. Die Schaltelemente 31 sind ferner zum elektromagnetischen, d.h. insbesondere induktiven, Erfassen des Leiterelementes ausgebildet. Alternativ ist beispielsweise ein kapazitives Erfassen des Leiterelementes denkbar. Beim Bewegen des zweiten Gehäuseabschnitts 12 von der Ruheposition I in die Betätigungsposition II werden die Schaltelemente 31 auf das Federelement 19 zubewegt, wodurch sich ein Abstand der Schaltelemente 31 zu dem Federelement 19 ändert. Eine dadurch hervorgerufene Änderung eines elektrischen und/oder magnetischen Feldes kann durch die Schaltelemente 31 erfasst werden. Zur Auswertung von Sensordaten des Schaltmittels 30 ist ferner eine Leiterplatte 17 im Gehäuseinnenraum 13 angeordnet, die eine Elektronik zur Auswertung von Sensordaten des Schaltmittels 30 aufweist. Vorzugsweise sind die Schaltelemente 31 auf einer dem ersten Gehäuseabschnitt 11 zugewandten Seite der Leiterplatte 17 an der Leiterplatte 17 angeordnet. Die Leiterplatte 17 ist dabei an einem insbesondere um die Leiterplatte 17 umlaufenden Haltemittel 12.1 angeordnet und mit der Vergussmasse 18 vergossen. Zusätzlich oder alternativ zur Vergussmasse 18 können die Schaltelemente 31 und/oder die Leiterplatte 17 mit einem Schutzlack bedeckt sein. Dadurch kann insbesondere die Elektronik vor Umwelteinflüssen geschützt sein. Durch die Elektronik können die Sensordaten ausgewertet oder vorausgewertet werden. Beispielsweise kann die Elektronik zur Fehlererkennung und/oder Digitalisierung der Sensorsignale ausgebildet sein.

Vorzugsweise umfasst das Schaltmittel 30 ferner ein Erfassungselement 33 zum Erfassen 101.1 einer Annäherung eines Benutzers, durch welches die Schaltelemente 31 bei der Annäherung des Benutzers von einem Deaktivierungszustand 210 in einen Aktivierungszustand 211 bringbar sind. Alternativ ist es ferner denkbar, dass das Erfassungsmittel 33 durch ein vom Schaltmittel 30 separates Modul gebildet ist. Im Deaktivierungszustand 210 ist ein, insbesondere manuelles, Betätigen der Schaltelemente 31 durch Bewegen des zweiten Gehäuseabschnitts 12 von der Ruheposition I in die Betätigungsposition II vorzugsweise elektronisch verhindert. So ist es denkbar, dass das Auslösen der Fahrzeugfunktion im Deaktivierungszustand 210 verhindert ist. Beispielsweise können die Schaltelemente 31 im Deaktivierungszustand 210 elektrisch deaktiviert und/oder elektrisch getrennt sein. Im Aktivierungszustand 211 ist das Betätigen der Schaltelemente 31 möglich. Das Erfassungsmittel 33 kann z.B. eine UWB- oder NFC-Schnittstelle, insbesondere in Form einer Antenne, umfassen, um eine Annäherung eines Benutzers an die Betätigungsvorrichtung 3 zu erfassen. Insbesondere erfolgt somit das Erfassen 101.1 der Annäherung des Benutzers und das Überführen der Schaltelemente 31 vom Deaktivierungszustand 210 in den Aktivierungszustand 211 vor dem Betätigen 101 der Schaltelemente 31.

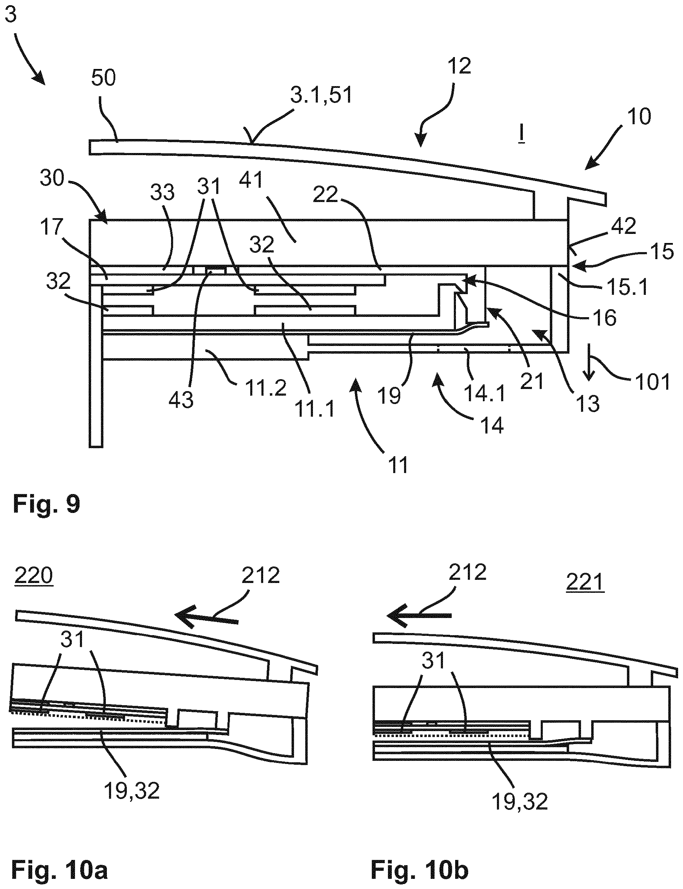

Die Figuren 10a und 10b zeigen ferner unterschiedliche Betätigungslagen 220, 221, in welche der zweite Gehäuseabschnitt 12 durch ein Streichen über die Betätigungsvorrichtung 3 bringbar ist. Vorzugsweise sind die Schaltelemente 31 in einer Betätigungsrichtung 212 angeordnet sind, so dass durch ein Streichen über die Betätigungsvorrichtung 3 eine Betätigungsfolge bewirkbar ist, in welcher die Schaltelemente 31 nacheinander betätigt werden. Beginnt ein Benutzer an einem äußeren Rand der Außenseite 3.1 seine Betätigungshandlung, kann vorgesehen sein, dass der zweite Gehäuseabschnitt 12 verkippt wird, indem der erste Gehäuseabschnitt 11 im Bereich der Betätigung stärker deformiert wird, als an der gegenüberliegenden Seite. Dadurch befinden sich die Schaltelemente 31 in unterschiedlichen Abständen zu dem Federelement 19. Setzt der Benutzer daraufhin seine Betätigungshandlung entlang der Betätigungsrichtung 212 fort, wie in Figur 10b dargestellt, richtet sich der zweite Gehäuseabschnitt 12 aus und die Abstände der Schaltelemente 31 zum Federelement 19 verändern sich entsprechend. Anhand der Abstände der Schaltelemente 31 kann detektiert werden, ob eine erste Betätigungslage 220 gemäß Figur 10a oder eine zweite Betätigungslage 221 gemäß Figur 10b vorliegt. Dadurch kann eine komplexere Betätigungshandlung erfassbar sein.

Weiterhin ist im Gehäuseinnenraum 13 eine Beleuchtungseinheit 40 zum Beleuchten der Betätigungsvorrichtung 3 angeordnet. Die Beleuchtungsvorrichtung 40 umfasst zumindest eine Lichtquelle 43, z.B. in Form einer LED, die im Gehäuseinnenraum 13, vorzugsweise auf der Leiterplatte 17, angeordnet ist. Insbesondere ist die Lichtquelle 43 auf einer dem zweiten Gehäuseabschnitt 12 zugewandten Seite der Leiterplatte 17 angeordnet. Weiterhin umfasst die Beleuchtungseinheit 40 einen Lichtleiter 41, der als transparentes Gehäuseelement des zweiten Gehäuseabschnitts 12 ausgebildet ist. Der Lichtleiter 41 weist ferner eine umlaufende Lichtaustrittsfläche 42 zur umlaufenden Beleuchtung der Betätigungsvorrichtung 3 umlaufend um den zweiten Gehäuseabschnitt 12. Insbesondere ist die Lichtaustrittsfläche 42 randseitig am Verbindungsbereich 15 angeordnet. Dadurch kann ein Lichtkreis um das Fahrzeugemblem 50 erzeugt werden, ohne dass ein Benutzer die Beleuchtungseinheit 40 selbst wahrnimmt.

Figur 7 zeigt eine Betätigungsvorrichtung 3 in einem weiteren Ausführungsbeispiel, die insbesondere an einem Fahrzeugteil 2 eines erfindungsgemäßen Fahrzeuges 1 montiert ist. Bei dem Fahrzeug 1 kann es sich um das Fahrzeug 1 gemäß Figur 5 handeln. Dabei ist die Betätigungsvorrichtung 3 insbesondere ähnlich der Betätigungsvorrichtung 3 ausgestaltet. Um eine Bewegung eines zweiten Gehäuseabschnitts 12 von einer Ruheposition I in eine Betätigungsposition II zum Betätigen eines elektrischen Schaltmittels 30 zu ermöglichen, weist ein erster Gehäuseabschnitt 11 ein umlaufendes Federelement 19 auf, das einen fluiddichten Verformungsbereich 14 des ersten Gehäuseabschnitts 11 bildet. Beispielsweise kann das Federelement 19 ringartig ausgebildet sein. Ferner ist das Federelement 19 mit einem Trägerelement 11.1 des ersten Gehäuseabschnitts 11 und dem zweiten Gehäuseabschnitt 12 vergossen. Am Trägerelement 11.1 ist unmittelbar eine Leiterplatte 17 angeordnet. Dadurch bildet das Federelement 19, d.h. insbesondere ein fest mit dem zweiten Gehäuseabschnitt 12 verbundener Abschnitt des Federelementes 19, einen Verbindungsabschnitt 15.1 eines stoffschlüssigen Verbindungsbereiches 14 zum Verbinden des ersten und zweiten Gehäuseabschnitts 11, 12. Zusätzlich oder alternativ kann ein Dichtmittel 20 vorgesehen sein, um den Verbindungsbereich 15 abzudichten und/oder eine stoffschlüssige Verbindung zu ermöglichen. Wie in Figur 8 gezeigt, übt das Federelement 19 eine Rückstellkraft 201 auf den zweiten Gehäuseabschnitt 12 aus, wenn sich der zweite Gehäuseabschnitt 12 in der Betätigungsposition II befindet.

Zum Auslösen einer Fahrzeugfunktion des Fahrzeuges 1 umfasst das elektrische Schaltmittel 30 ferner eine elektromagnetische Sensoreinheit mit zumindest einem Auslöserelement 32 in Form eines elektrisch leitfähigen Leiterelementes und zumindest einem Schaltelement 31, das am zweiten Gehäuseabschnitt 12 angeordnet ist. Das Leiterelement 32 ist dabei in den ersten Gehäuseabschnitt 11 integriert oder am ersten Gehäuseabschnitt 11 angeordnet. Dadurch wird ein Abstand zwischen dem Leiterelement und dem Schaltelement 31 bei der Bewegung des zweiten Gehäuseabschnitts 12 von der Ruheposition I in die Betätigungsposition II verringert. Die Verringerung des Abstands ist durch das Schaltelement 31 induktiv oder kapazitiv erfassbar. Zwischen dem ersten und zweiten Gehäuseabschnitt 11, 12 ist ferner ein Zwischenelement 22 angeordnet, das ein Positionierelement 21.1 eines Positioniermittels 21 zum formschlüssigen Festlegen der Ruheposition I des zweiten Gehäuseabschnitts 12 aufweist. Dadurch kann der zweite Gehäuseabschnitt 12 eine einfach zu fertigende Form aufweisen und/oder das Schaltelement 31 kann zwischen dem Zwischenelement 22 und dem zweiten Gehäuseabschnitt 12 fixiert sein. Insbesondere ist das Zwischenelement 22 am zweiten Gehäuseabschnitt 12 in einem Gehäuseinnenraum 13 befestigt.

Figur 9 zeigt eine Betätigungsvorrichtung 3 in einem weiteren Ausführungsbeispiel, die insbesondere an einem Fahrzeugteil 2 eines erfindungsgemäßen Fahrzeuges 1 montiert ist. Bei dem Fahrzeug 1 kann es sich um das Fahrzeug 1 gemäß Figur 5 handeln. Dabei entspricht die Betätigungsvorrichtung 3 des Ausführungsbeispiels der Figur 9 im Wesentlichen der Betätigungsvorrichtung 3 des Ausführungsbeispiels der Figur 7. Allerdings bildet gemäß Figur 9 ein Abdeckelement 11.2 eines ersten Gehäuseabschnitts 11 einen fluiddichten Verformungsbereich 14 und einen Verbindungsabschnitt 15.1 eines Verbindungsbereiches 15 zum Verbinden des ersten Gehäuseabschnitts 11 mit einem zweiten Gehäuseabschnitt 12 einer Gehäuseeinheit 10 der Betätigungsvorrichtung 3. Das Abdeckelement 11.2 kann materialeinheitlich ausgebildet sein oder als Zweikomponenten-Kunststoffspritzgussteil ausgestaltet sein und im Verformungsbereich 14 eine Weichkomponente 14.1 aufweisen. Zusätzlich weist die Betätigungsvorrichtung 3 in einem Gehäuseinnenraum 13, der durch den ersten und zweiten Gehäuseabschnitt 11, 12 gebildet ist, ein Federelement 19 auf, das daher durch die Gehäuseeinheit 10 geschützt ist. Dadurch ergibt sich ein Federverhalten gemäß Figur 4, wenn der zweite Gehäuseabschnitt 12 von einer Ruheposition I in eine Betätigungsposition II zum Betätigen eines elektrischen Schaltmittels 30 bewegt wird.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung, wie in den Ansprüchen definiert ist, zu verlassen.

### Bezugszeichenliste

- 1: Fahrzeug
- 2: Fahrzeugteil
- 3: Betätigungsvorrichtung
- 3.1: Außenseite
- 4: Befestigungsmittel

- 10: Gehäuseeinheit
- 11: erster Gehäuseabschnitt
- 11.1: Trägerelement
- 11.2: Abdeckelement
- 12: zweiter Gehäuseabschnitt
- 12.1: Haltemittel
- 13: Gehäuseinnenraum
- 14: Verformungsbereich
- 15: Verbindungsbereich
- 15.1: Verbindungsabschnitt
- 16: Bewegungsfreiraum
- 17: Leiterplatte
- 18: Vergussmasse
- 19: Federelement
- 19.1: Federbereich
- 20: Dichtmittel
- 21: Positioniermittel
- 21.1: Positionierelement
- 22: Zwischenelement
- 23: Ausgleichselement
- 24: Verkabelung

- 30: Schaltmittel
- 31: Schaltelement
- 32: Auslöserelement, insbesondere Leiterelement
- 33: Erfassungselement

- 40: Beleuchtungseinheit
- 41: Lichtleiter
- 42: Lichtaustrittsfläche
- 43: Lichtquelle

- 50: Fahrzeugemblem
- 51: Betätigungsfläche

- 100: Betätigungsverfahren
- 101: Aktivieren
- 102: Zurückstellen

- 200: Gesamtkraft
- 201: Rückstellkraft von 19
- 202: Rückstellkraft von 14

- 210: Deaktivierungszustand
- 211: Aktivierungszustand
- 212: Betätigungsrichtung

- 220: erste Betätigungslage
- 221: zweite Betätigungslage

- I: Ruheposition
- II: Betätigungsposition

## Patentansprüche

1. Betätigungsvorrichtung (3) zur Montage an einem Fahrzeugteil (2), insbesondere in Form einer Tür oder einer Klappe, aufweisend
ein elektrisches Schaltmittel (30) mit zumindest einem elektrischen Schaltelement (31) zum Auslösen einer Fahrzeugfunktion, und
eine Gehäuseeinheit (10) mit zumindest einem ersten und einem zweiten Gehäuseabschnitt (11, 12),
wobei der zweite Gehäuseabschnitt (12) von einer Ruheposition (I) in eine Betätigungsposition (II) zum Betätigen des Schaltelementes (31) zumindest bereichsweise relativ zu dem ersten Gehäuseabschnitt (11) bewegbar ist, wobei das Schaltmittel (30) zumindest ein Auslöserelement (32) zum Betätigen des Schaltelementes (31) aufweist,
**dadurch gekennzeichnet,**
**dass** das Schaltelement (31) am zweiten Gehäuseabschnitt (12) angeordnet ist, so dass das Schaltelement (31) bei der Bewegung des zweiten Gehäuseabschnitts (12) von der Ruheposition (I) in die Betätigungsposition (II) mitbewegt wird,
wobei das Auslöserelement (32) am ersten Gehäuseabschnitt (11) angeordnet ist, so dass das Schaltelement (31) beim Bewegen des zweiten Gehäuseabschnitts (12) von der Ruheposition (I) in die Betätigungsposition (II) auf das Auslöserelement (32) zubewegt wird.

2. Betätigungsvorrichtung (3) nach Anspruch 1,
**dadurch gekennzeichnet,**
**dass** der erste und zweite Gehäuseabschnitt (11, 12) zumindest teilweise einen Gehäuseinnenraum (13) bilden, in welchem das Schaltelement (31) angeordnet ist, und/oder dass sich der Gehäuseinnenraum (13) zumindest bereichsweise zwischen dem zweiten Gehäuseabschnitt (12) und einem fluiddichten Verformungsbereich (14) des ersten Gehäuseabschnitts (11) erstreckt, der mit einem umlaufenden Verbindungsbereich (15) des ersten und zweiten Gehäuseabschnittes (11, 12) mechanisch gekoppelt ist, so dass der Verbindungsbereich (15) bei der Bewegung des zweiten Gehäuseabschnitts (12) von der Ruheposition (I) in die Betätigungsposition (II) mitbewegbar ist.

3. Betätigungsvorrichtung (3) nach Anspruch 2,
**dadurch gekennzeichnet,**
**dass** der Verbindungsbereich (15) zur fluiddichten Verbindung des ersten und zweiten Gehäuseabschnitts (11, 12) ausgebildet ist, insbesondere wobei der Verbindungsbereich (15) eine kontinuierlich umlaufende Verbindung des ersten und zweiten Gehäuseabschnitts (11, 12) umfasst,
und/oder dass der Verbindungsbereich (15) eine stoffschlüssige Verbindung des ersten und zweiten Gehäuseabschnitts (11, 12) umfasst, insbesondere wobei der erste Gehäuseabschnitt (11) mit dem zweiten Gehäuseabschnitt (12) verklebt oder verschweißt ist.

4. Betätigungsvorrichtung (3) nach einem der vorhergehenden Ansprüche,
**dadurch gekennzeichnet,**
**dass** das Schaltmittel (30) eine elektromagnetische Sensoreinheit mit einem elektrisch leitfähigen Leiterelement umfasst, welches das Auslöserelement (32) bildet, wobei das Schaltelement (31) zum elektromagnetischen, insbesondere induktiven oder kapazitiven, Erfassen des Leiterelementes ausgebildet ist.

5. Betätigungsvorrichtung (3) nach einem der vorhergehenden Ansprüche,
**dadurch gekennzeichnet,**
**dass** das Schaltmittel (30) ein Erfassungselement (33) zum Erfassen einer Annäherung eines Benutzers umfasst, durch welches das Schaltelement (31) bei der Annäherung des Benutzers von einem Deaktivierungszustand (210), in welchem das Auslösen der Fahrzeugfunktion durch das Schaltelement (31) verhindert ist, in einen Aktivierungszustand (211) bringbar ist, in welchem das Auslösen der Fahrzeugfunktion durch das Schaltelement (31) ermöglicht ist.

6. Betätigungsvorrichtung (3) nach einem der vorhergehenden Ansprüche,
**dadurch gekennzeichnet,**
**dass** das Schaltmittel (30) zumindest zwei elektrische Schaltelemente (31) aufweist, die in einer Betätigungsrichtung (212) angeordnet sind, so dass durch ein Streichen über die Betätigungsvorrichtung (3) eine Betätigungsfolge bewirkbar ist, in welcher die Schaltelemente (31) nacheinander und/oder unterschiedlich betätigt werden,
und/oder dass das Schaltmittel (30) an einer Leiterplatte (17) angeordnet ist, die am zweiten Gehäuseabschnitt (12) befestigt ist, insbesondere wobei die Leiterplatte (17) eine Elektronik zur Auswertung von Sensordaten des Schaltmittels (30) aufweist, und/oder dass die Leiterplatte (17) mit einer Vergussmasse (18) vergossen ist oder mit einem Schutzlack bedeckt ist.

7. Betätigungsvorrichtung (3) nach Anspruch 2 bis 3 oder nach Anspruch 4 bis 6 wenn sie zumindest von Anspruch 2 abhängig sind,
**dadurch gekennzeichnet,**
**dass** der erste Gehäuseabschnitt (11, 12) ein Abdeckelement (11.2) aufweist, welches einen Verbindungsabschnitt (15.1) des Verbindungsbereiches (15) bildet,
und/oder dass das Abdeckelement (11.2) den Verformungsbereich (14) bildet, insbesondere wodurch eine Rückstellkraft (202) entgegen der Bewegung des zweiten Gehäuseabschnitts (12) von der Ruheposition (I) in die Betätigungsposition (II) durch das Abdeckelement (11.2) ausübbar ist.

8. Betätigungsvorrichtung (3) nach einem der vorhergehenden Ansprüche,
**dadurch gekennzeichnet,**
**dass** die Gehäuseeinheit (10) ein Federelement (19) zum Ausüben einer Rückstellkraft (201) entgegen der Bewegung des zweiten Gehäuseabschnitts (12) von der Ruheposition (I) in die Betätigungsposition (II) aufweist, insbesondere wobei das Federelement (19) im Gehäuseinnenraum (13) angeordnet ist,
und/oder dass das Federelement (19) das Auslöserelement (32) des Schaltmittels (30) bildet, insbesondere wobei eine Verkürzung eines Abstands des Federelementes (19) zum Schaltelement (31) durch das Schaltelement (31) erfassbar ist, wenn der zweite Gehäuseabschnitt (12) von der Ruheposition (I) in die Betätigungsposition (II) bewegt wird,
und/oder dass der Verbindungsbereich (15) das Federelement (19) aufweist, wobei sich das Federelement (19) umlaufend im Verbindungsbereich (15) erstreckt.

9. Betätigungsvorrichtung (3) nach Anspruch 8,
**dadurch gekennzeichnet,**
**dass** das Federelement (19) form- und/oder stoffschlüssig mit dem zweiten Gehäuseabschnitt (12) verbunden ist, insbesondere wobei das Federelement (19) bereichsweise in ein Gehäusematerial des zweiten Gehäuseabschnitts (12) eingebettet oder eingeklemmt ist oder wobei das Federelement (19) durch ein Dichtmittel (20) mit dem zweiten Gehäuseabschnitt (12) verklebt ist.

10. Betätigungsvorrichtung (3) nach einem der vorhergehenden Ansprüche,
**dadurch gekennzeichnet,**
**dass** die Gehäuseeinheit (10) ein Positioniermittel (21) aufweist, durch welches die Ruheposition (I) des zweiten Gehäuseabschnitts (12), insbesondere formschlüssig, festlegbar ist,
und/oder dass zwischen dem ersten und zweiten Gehäuseabschnitt (11, 12) ein Zwischenelement (22) angeordnet ist, durch welches die Rückstellkraft (201) des Federelementes (19) an den zweiten Gehäuseabschnitt (11, 12) übertragbar ist und/oder welches zumindest ein Positionierelement (21.1) des Positioniermittels (21) aufweist.

11. Betätigungsvorrichtung (3) nach einem der vorhergehenden Ansprüche,
**dadurch gekennzeichnet,**
**dass** im Gehäuseinnenraum (13) eine Beleuchtungseinheit (40) zum Beleuchten der Betätigungsvorrichtung (3) anordnet ist,
und/oder dass der zweite Gehäuseabschnitt (12) einen Lichtleiter (41) zum Leiten von Licht der Beleuchtungseinheit (40) aufweist, insbesondere wobei der Lichtleiter (41) eine Lichtaustrittsfläche (42) aufweist, die zur umlaufenden Beleuchtung der Betätigungsvorrichtung (3) umlaufend um den zweiten Gehäuseabschnitt (12) ausgebildet ist.

12. Betätigungsvorrichtung (3) nach einem der vorhergehenden Ansprüche,
**dadurch gekennzeichnet,**
**dass** der zweite Gehäuseabschnitt (12) ein Fahrzeugemblem (50) aufweist, welches eine Betätigungsfläche (51) zum Auslösen der Bewegung des zweiten Gehäuseabschnitts (12) von der Ruheposition (I) in die Betätigungsposition (II) bildet, insbesondere wobei das Fahrzeugemblem (50) eine Außenseite (3.1) der Betätigungsvorrichtung (3) bildet.

13. Betätigungsvorrichtung (3) nach Anspruch 2, 3, 7 oder nach Anspruch 4, 5, 6, 8, 9, 10, 11, 12 wenn sie zumindest von Anspruch 2 abhängig sind,
**dadurch gekennzeichnet,**
**dass** der Gehäuseinnenraum (13) ein Ausgleichselement (23) zum Luftaustausch mit einer Umgebung aufweist, insbesondere wobei das Ausgleichselement (23) an einer Kabelführung für das Schaltmittel (30) und/oder die Leiterplatte (17) angeordnet ist.

14. Fahrzeug (1) aufweisend
ein Fahrzeugteil (2), insbesondere in Form einer Tür oder einer Klappe,
**dadurch gekennzeichnet,**
**dass** an dem Fahrzeugteil (2) eine Betätigungsvorrichtung (3) nach einem der vorhergehenden Ansprüche zum Auslösen einer Fahrzeugfunktion des Fahrzeuges (1) angeordnet ist.

15. Betätigungsverfahren (100) zum Auslösen einer Fahrzeugfunktion eines Fahrzeuges (1) durch eine Betätigungsvorrichtung (3) nach einem der Ansprüche 1 bis 13 mit zumindest einem ersten und einem zweiten Gehäuseabschnitt (11, 12), umfassend die folgenden Schritte:
- Betätigen (101) eines elektrischen Schaltelementes (31) eines elektrischen Schaltmittels (30) zum Auslösen der Fahrzeugfunktion durch Bewegen des zweiten Gehäuseabschnitts (12) mit dem Schaltelement (31) von einer Ruheposition (I) in eine Betätigungsposition (II),
- Elastisches Zurückstellen (102) des zweiten Gehäuseabschnitts (12) mit dem Schaltelement (31) in die Ruheposition (I).

## Claims

1. Actuating device (3) for mounting on a vehicle part (2), in particular in the form of a door or a flap, comprising
an electrical switching means (30) with at least one electrical switching element (31) for triggering a vehicle function, and
a housing unit (10) with at least a first and a second housing section (11, 12),
wherein the second housing section (12) is movable from a rest position (I) into an actuating position (II) for actuating the switching element (31) at least in certain regions relative to the first housing section (11), wherein the switching means (30) has at least one trigger element (32) for actuating the switching element (31),
**characterized in that**
the switching element (31) is arranged on the second housing section (12), so that the switching element (31) is moved along with the movement of the second housing section (12) from the rest position (I) into the actuating position (II),
wherein the trigger element (32) is arranged on the first housing section (11), so that the switching element (31) is moved towards the trigger element (32) when the second housing section (12) is moved from the rest position (I) into the actuating position (II).

2. Actuating device (3) according to claim 1,
**characterized in that**
the first and second housing sections (11, 12) at least partially form a housing interior (13) in which the switching element (31) is arranged,
and/or **in that** the housing interior (13) extends at least in certain regions between the second housing section (12) and a fluid-tight deformation region (14) of the first housing section (11), which is mechanically coupled to a circumferential connection region (15) of the first and second housing sections (11, 12), so that the connection region (15) can be moved with the movement of the second housing section (12) from the rest position (I) into the actuating position (II).

3. Actuating device (3) according to claim 2,
**characterized in that**
the connection region (15) is designed for fluid-tight connection of the first and second housing sections (11, 12), in particular wherein the connection region (15) comprises a continuously circulating connection of the first and second housing sections (11, 12), and/or **in that** the connection region (15) comprises a material-locking connection of the first and second housing sections (11, 12), in particular wherein the first housing section (11) is bonded or welded to the second housing section (12).

4. Actuating device (3) according to one of the preceding claims,
**characterized in that**
the switching means (30) comprises an electromagnetic sensor unit with an electrically conductive conductor element which forms the trigger element (32), the switching element (31) being designed for electromagnetic, in particular inductive or capacitive, detection of the conductor element.

5. Actuating device (3) according to one of the preceding claims,
**characterized in that**
the switching means (30) comprises a detection element (33) for detecting the approach of a user, by means of which the switching element (31), when the user approaches, can be brought from a deactivation state (210), in which the triggering of the vehicle function by the switching element (31) is prevented, into an activation state (211), in which the triggering of the vehicle function by the switching element (31) is enabled.

6. Actuating device (3) according to one of the preceding claims,
**characterized in that**
the switching means (30) has at least two electrical switching elements (31) which are arranged in an actuating direction (212), so that an actuating sequence in which the switching elements (31) are actuated successively and/or differently can be brought about by a sweep over the actuating device (3),
and/or **in that** the switching means (30) is arranged on a printed circuit board (17) which is fastened to the second housing section (12), in particular wherein the printed circuit board (17) has electronics for evaluating sensor data of the switching means (30), and/or that the printed circuit board (17) is encapsulated with a casting compound (18) or covered with a protective coating.

7. Actuating device (3) according to any one of the claims 2 to 3 or according to any one of the claims 4 to 6 if they are at least dependent on claim 2,
**characterized in that**
the first housing section (11, 12) has a cover element (11.2) which forms a connection section (15.1) of the connecting region (15),
and/or that the cover element (11.2) forms the deformation region (14), in particular whereby a restoring force (202) can be exerted by the cover element (11.2) counter to the movement of the second housing section (12) from the rest position (I) into the actuating position (II).

8. Actuating device (3) according to one of the preceding claims,
**characterized in that**
the housing unit (10) has a spring element (19) for exerting a restoring force (201) counter to the movement of the second housing section (12) from the rest position (I) into the actuating position (II), in particular wherein the spring element (19) is arranged in the housing interior (13),
and/or that the spring element (19) forms the trigger element (32) of the switching means (30), in particular wherein a shortening of a distance between the spring element (19) and the switching element (31) can be detected by the switching element (31) when the second housing section (12) is moved from the rest position (I) into the actuating position (II),
and/or **in that** the connection region (15) has the spring element (19), the spring element (19) extending circumferentially in the connection region (15).

9. Actuating device (3) according to claim 8,
**characterized in that**
the spring element (19) is connected to the second housing section (12) in a form-fitting and/or material-fitting manner, in particular wherein the spring element (19) is embedded or clamped in regions in a housing material of the second housing section (12) or wherein the spring element (19) is bonded to the second housing section (12) by a sealing means (20).

10. Actuating device (3) according to one of the preceding claims,
**characterized in that**
the housing unit (10) has a positioning means (21) by means of which the rest position (I) of the second housing section (12) can be fixed, in particular in a form-fitting manner, and/or **in that** an intermediate element (22) is arranged between the first and second housing sections (11, 12), through which the restoring force (201) of the spring element (19) can be transmitted to the second housing section (11, 12) and/or which has at least one positioning element (21.1) of the positioning means (21).

11. Actuating device (3) according to one of the preceding claims,
**characterized in that**
an illumination unit (40) for illuminating the actuating device (3) is arranged in the housing interior (13),
and/or **in that** the second housing section (12) has a light guide (41) for guiding light from the illumination unit (40), in particular wherein the light guide (41) has a light-emitting surface (42) which is designed to revolve around the second housing section (12) for revolving illumination of the actuating device (3).

12. Actuating device (3) according to one of the preceding claims,
**characterized in that**
the second housing section (12) has a vehicle emblem (50) which forms an actuating surface (51) for triggering the movement of the second housing section (12) from the rest position (I) into the actuating position (II), in particular wherein the vehicle emblem (50) forms an outer side (3.1) of the actuating device (3).

13. Actuating device (3) according to any one of the claims 2, 3, 7 or according to any one of the claims 4, 5, 6, 8, 9, 10, 11, 12 if they are at least dependent on claim 2,
**characterized in that**
the housing interior (13) has an equalizing element (23) for air exchange with an environment, in particular wherein the equalizing element (23) is arranged on a cable guide for the switching means (30) and/or the printed circuit board (17).

14. Vehicle (1) comprising
a vehicle part (2), in particular in the form of a door or a flap,
**characterized in that**
an actuating device (3) according to one of the preceding claims for triggering a vehicle function of the vehicle (1) is arranged on the vehicle part (2).

15. An actuating method (100) for triggering a vehicle function of a vehicle (1) by an actuating device (3) according to any one of claims 1 to 13, comprising at least a first and a second housing section (11, 12), comprising the following steps:
- Actuation (101) of an electrical switching element (31) of an electrical switching means (30) for triggering the vehicle function by moving the second housing section (12) with the switching element (31) from a rest position (I) to an actuation position (II),
- Resilient return (102) of the second housing section (12) with the switching element (31) to the rest position (I).

## Revendications

1. Dispositif d'actionnement (3) destiné à être monté sur une partie de véhicule (2), en particulier sous la forme d'une porte ou d'un volet, présentant
un moyen de commutation électrique (30) comprenant au moins un élément de commutation électrique (31) pour déclencher une fonction du véhicule, et
une unité de boîtier (10) comprenant au moins une première et une deuxième sections de boîtier (11, 12),
la deuxième section de boîtier (12) pouvant être déplacée au moins par zones par rapport à la première section de boîtier (11) d'une position de repos (I) dans une position d'actionnement (II) pour actionner l'élément de commutation (31), le moyen de commutation (30) présentant au moins un élément de déclenchement (32) pour actionner l'élément de commutation (31),
**caractérisé en ce que**
l'élément de commutation (31) est disposé sur la deuxième section de boîtier (12), de sorte que l'élément de commutation (31) est déplacé conjointement lors du mouvement de la deuxième section de boîtier (12) de la position de repos (I) à la position d'actionnement (II),
l'élément de déclenchement (32) étant disposé sur la première section de boîtier (11), de sorte que l'élément de commutation (31) est déplacé vers l'élément de déclenchement (32) lorsque la deuxième section de boîtier (12) est déplacée de la position de repos (I) à la position d'actionnement (II).

2. Dispositif d'actionnement (3) selon la revendication 1,
**caractérisé en ce que**
la première et la deuxième section de boîtier (11, 12) forment au moins partiellement un espace intérieur de boîtier (13) dans lequel est disposé l'élément de commutation (31),
et/ou **en ce que** l'espace intérieur de boîtier (13) s'étend au moins par zones entre la deuxième section de boîtier (12) et une zone de déformation (14) étanche aux fluides de la première section de boîtier (11), qui est couplée mécaniquement à une zone de liaison (15) périphérique de la première et de la deuxième section de boîtier (11, 12), de sorte que la zone de liaison (15) peut être déplacée conjointement lors du mouvement de la deuxième section de boîtier (12) de la position de repos (I) à la position d'actionnement (II).

3. Dispositif d'actionnement (3) selon la revendication 2,
**caractérisé en ce que**
la zone de liaison (15) est réalisée pour la liaison étanche au fluide de la première et de la deuxième section de boîtier (11, 12), en particulier la zone de liaison (15) comprenant une liaison périphérique continue de la première et de la deuxième section de boîtier (11, 12),
et/ou **en ce que** la zone de liaison (15) comprend une liaison par matière de la première et de la deuxième section de boîtier (11, 12), en particulier la première section de boîtier (11) étant collée ou soudée à la deuxième section de boîtier (12).

4. Dispositif d'actionnement (3) selon l'une quelconque des revendications précédentes, **caractérisé en ce que**
le moyen de commutation (30) comprend une unité de détection électromagnétique avec un élément conducteur électriquement conducteur, qui forme l'élément de déclenchement (32), l'élément de commutation (31) étant conçu pour la détection électromagnétique, en particulier inductive ou capacitive, de l'élément conducteur.

5. Dispositif d'actionnement (3) selon l'une quelconque des revendications précédentes, **caractérisé en ce que**
le moyen de commutation (30) comprend un élément de détection (33) pour détecter une approche d'un utilisateur, grâce auquel l'élément de commutation (31) peut être amené, lors de l'approche de l'utilisateur, d'un état de désactivation (210), dans lequel le déclenchement de la fonction du véhicule par l'élément de commutation (31) est empêché, dans un état d'activation (211), dans lequel le déclenchement de la fonction du véhicule par l'élément de commutation (31) est possible.

6. Dispositif d'actionnement (3) selon l'une quelconque des revendications précédentes, **caractérisé en ce que**
le moyen de commutation (30) présente au moins deux éléments de commutation électriques (31) qui sont disposés dans une direction d'actionnement (212), de sorte qu'en passant sur le dispositif d'actionnement (3), on peut provoquer une séquence d'actionnement dans laquelle les éléments de commutation (31) sont actionnés successivement et/ou différemment,
et/ou **en ce que** le moyen de commutation (30) est disposé sur une carte imprimée (17) qui est fixée sur la deuxième section de boîtier (12), en particulier la carte imprimée (17) présentant une électronique pour l'évaluation de données de capteur du moyen de commutation (30),
et/ou **en ce que** la carte de circuit imprimé (17) est scellée avec une masse de scellement (18) ou est recouverte d'un vernis de protection.

7. Dispositif d'actionnement (3) selon les revendications 2 à 3 ou selon les revendications 4 à 6 lorsqu'ils dépendent au moins de la revendication 2,
**caractérisé en ce que**
la première section de boîtier (11, 12) présente un élément de recouvrement (11.2) qui forme une section de liaison (15.1) de la zone de liaison (15),
et/ou **en ce que** l'élément de recouvrement (11.2) forme la zone de déformation (14), grâce à quoi une force de rappel (202) peut être exercée par l'élément de recouvrement (11.2) à l'encontre du mouvement de la deuxième section de boîtier (12) de la position de repos (I) dans la position d'actionnement (II).

8. Dispositif d'actionnement (3) selon l'une quelconque des revendications précédentes, **caractérisé en ce que**
l'unité de boîtier (10) présente un élément de ressort (19) pour exercer une force de rappel (201) à l'encontre du mouvement de la deuxième section de boîtier (12) de la position de repos (I) dans la position d'actionnement (II), en particulier l'élément de ressort (19) étant disposé dans l'espace intérieur du boîtier (13),
et/ou **en ce que** l'élément de ressort (19) forme l'élément de déclenchement (32) du moyen de commutation (30), en particulier un raccourcissement d'une distance de l'élément de ressort (19) par rapport à l'élément de commutation (31) pouvant être détecté par l'élément de commutation (31) lorsque la deuxième section de boîtier (12) est déplacée de la position de repos (I) dans la position d'actionnement (II),
et/ou **en ce que** la zone de liaison (15) présente l'élément de ressort (19), l'élément de ressort (19) s'étendant de manière périphérique dans la zone de liaison (15).

9. Dispositif d'actionnement (3) selon la revendication 8,
**caractérisé en ce que**
l'élément de ressort (19) est relié par complémentarité de forme et/ou de matière à la deuxième section de boîtier (12), en particulier l'élément de ressort (19) étant noyé ou coincé par zones dans un matériau de boîtier de la deuxième section de boîtier (12) ou l'élément de ressort (19) étant collé à la deuxième section de boîtier (12) par un moyen d'étanchéité (20).

10. Dispositif d'actionnement (3) selon l'une quelconque des revendications précédentes, **caractérisé en ce que**
l'unité de boîtier (10) présente un moyen de positionnement (21) par lequel la position de repos (I) de la deuxième section de boîtier (12) peut être fixée, en particulier par complémentarité de formes,
et/ou **en ce qu'**entre la première et la deuxième section de boîtier (11, 12) est disposé un élément intermédiaire (22) par lequel la force de rappel (201) de l'élément de ressort (19) peut être transmise à la deuxième section de boîtier (11, 12) et/ou qui présente au moins un élément de positionnement (21.1) du moyen de positionnement (21).

11. Dispositif d'actionnement (3) selon l'une quelconque des revendications précédentes, **caractérisé en ce qu'**
une unité d'éclairage (40) est disposée dans l'espace intérieur (13) du boîtier pour éclairer le dispositif d'actionnement (3),
et/ou **en ce que** la deuxième section de boîtier (12) présente un guide de lumière (41) pour guider la lumière de l'unité d'éclairage (40), en particulier le guide de lumière (41) présentant une surface de sortie de lumière (42) qui est conçue pour l'éclairage périphérique du dispositif d'actionnement (3) en faisant le tour de la deuxième section de boîtier (12).

12. Dispositif d'actionnement (3) selon l'une quelconque des revendications précédentes, **caractérisé en ce que**
la deuxième section de boîtier (12) présente un emblème de véhicule (50) qui forme une surface d'actionnement (51) pour déclencher le mouvement de la deuxième section de boîtier (12) de la position de repos (I) à la position d'actionnement (II), en particulier l'emblème de véhicule (50) formant un côté extérieur (3.1) du dispositif d'actionnement (3).

13. Dispositif d'actionnement (3) selon la revendication 2, 3, 7 ou selon la revendication 4, 5, 6, 8, 9, 10, 11, 12 lorsqu'ils dépendent au moins de la revendication 2,
**caractérisé en ce que**
l'espace intérieur (13) du boîtier présente un élément de compensation (23) pour l'échange d'air avec un environnement, en particulier l'élément de compensation (23) étant disposé sur un guide-câble pour le moyen de commutation (30) et/ou la carte imprimée (17).

14. Véhicule (1) comprenant
un élément de véhicule (2), notamment sous la forme d'une porte ou d'un volet, **caractérisé en ce qu'**
un dispositif d'actionnement (3) selon l'une des revendications précédentes est disposé sur la partie de véhicule (2) pour déclencher une fonction de véhicule du véhicule (1).

15. Procédé d'actionnement (100) pour déclencher une fonction de véhicule d'un véhicule (1) par un dispositif d'actionnement (3) selon l'une quelconque des revendications 1 à 13 ayant au moins une première et une deuxième sections de boîtier (11, 12), comprenant les étapes suivantes :
- Actionner (101) un élément de commutation électrique (31) d'un moyen de commutation électrique (30) pour déclencher la fonction du véhicule en déplaçant la deuxième section de boîtier (12) avec l'élément de commutation (31) d'une position de repos (I) à une position d'actionnement (II),
- Rappel élastique (102) de la deuxième section de boîtier (12) avec l'élément de commutation (31) dans la position de repos (I).
